(19) Europäisches Patentamt European Patent Office Office européen des brevets

(11) **EP 2 717 330 A1**

(12) **EUROPEAN PATENT APPLICATION**
published in accordance with Art. 153(4) EPC

(43) Date of publication:
09.04.2014 Bulletin 2014/15

(21) Application number: 12793048.5

(22) Date of filing: 25.05.2012

(51) Int Cl.:
$H01L\ 31/042^{(2014.01)}$ $B23K\ 35/26^{(2006.01)}$
$C23C\ 2/08^{(2006.01)}$ $C23C\ 2/10^{(2006.01)}$
$C23C\ 2/38^{(2006.01)}$

(86) International application number:
PCT/JP2012/063527

(87) International publication number:
WO 2012/165348 (06.12.2012 Gazette 2012/49)

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR

(30) Priority: 27.05.2011 JP 2011119643
27.05.2011 JP 2011119562

(71) Applicant: Nippon Steel & Sumitomo Metal
Corporation
Tokyo 100-8071 (JP)

(72) Inventors:
• KOBAYASHI, Takayuki
Tokyo 100-8071 (JP)
• KIMURA, Keiichi
Tokyo 100-8071 (JP)
• TANAKA, Masamoto
Tokyo 100-8071 (JP)
• HASHINO, Eiji
Tokyo 100-8071 (JP)

(74) Representative: Vossius & Partner
Siebertstrasse 4
81675 München (DE)

(54) **INTERCONNECTOR FOR SOLAR CELLS, AND SOLAR CELL MODULE**

(57) The purpose of the present invention is to provide an interconnector for solar cells, which reduces the stress acting on a solar cell and suppresses warping and cracking of the solar cell. An interconnector for solar cells of the present invention is characterized by comprising an electrically conductive wire part and a surface layer that is formed on at least one wide surface of the electrically conductive wire part. The interconnector for solar cells is also characterized in that the surface layer has a function of reducing the stress that is caused by the difference between the thermal expansion coefficient of the electrically conductive part and the thermal expansion coefficient of a solar cell, said stress being generated when the interconnector is joined to the solar cell.

Fig.3

EP 2 717 330 A1

**Description**

FIELD

This invention relates to a solar cell interconnector used for solar cell current collection, a method of producing the same, and a solar module.

BACKGROUND

Solar module power generation is a method of generating power by directly converting inexhaustible solar energy into electric energy. Viewed as a technology for significantly alleviating energy issues, solar module power generation has therefore been intensely researched and developed in recent years, and its market has also expanded considerably.

Currently, single-crystal silicon substrates and polycrystal silicon substrates are widely used for the substrates of solar modules. A solar module that uses a single-crystal silicon substrate or the like is formed by series-connecting a number of substrates, called solar cells, that measure about 20 cm square in size. The multiple solar cells forming the solar module are interconnected by collector wires for collecting the electrical energy generated by the individual solar cells. Molten-phase bonding with solder is widely adopted for the connections between the solar cells and the collector wires. The collector wire is known as an interconnector or interconnector for current collection and is formed from solder-coated metal conductor wire (see, for example, Patent Document 1).

The solar module is an energy device that outputs electric power as electric current. From this it follows that the cross-sectional area of the interconnector in its direction orthogonal to current flow and the area of the connection surface between the interconnector and the solar cell need to be determined with consideration to the amount of current flowing through the interconnector. As solar cells have grown in size and improved in efficiency, current flow through the interconnector has increased. This has made it necessary to reduce interconnector power loss by enlarging the interconnector cross-sectional area and the connection surface area between interconnector and solar cell.

In order to bond an interconnector to a solar cell, it is necessary to perform liquid-phase bonding by heating the interconnector, solar cell and solder used as the bonding material and then cool to room temperature. In this cooling process, stress occurs because of the difference between the coefficient of thermal expansion of the silicon that is the main constituent of the solar cell and the coefficient of thermal expansion of the metal forming the electrical conductor portion that is the main constituent of the interconnector. The typical coefficients of linear thermal expansion of metal and silicon in the vicinity of room temperature are $16.6 \times 10^{-6}$ ($K^{-1}$) for copper, $19 \times 10^{-6}$ ($K^{-1}$) for silver, $25 \times 10^{-6}$ ($K^{-1}$) for aluminum, and $3 \times 10^{-6}$ ($K^{-1}$) for silicon. When copper and silicon are bonded at 200 °C, a length difference of about 0.26% arises. And this length difference produces stress between the copper and silicon, so that warping arises in the solar cell formed of silicon.

Moreover, in order to cope with tight silicon material supplies and lower the cost of solar cells, the thickness of silicon substrates used in solar cells is being reduced. For example, very thin silicon substrates of 180 $\mu$m-order thickness have come to be used in solar cells. Breakage of solar cells by stress has therefore become a greater problem than in the past. Moreover, even when a solar cell does not reach the point of breakage, the light-receiving surface of the solar cell is liable to be bent by warping.

Attempts have been made to overcome this problem by softening the interconnector (see, for example, Non-patent Document 1). In order to deal with the problem caused by difference in coefficient of thermal expansion between metal and silicon, it is important to soften the interconnector, i.e., to lower its Young's modulus and yield stress. In general, 0.2% proof stress is usually used as an index of the yield stress of a metal. Also in the case of an interconnector, strain can be expected to be induced on the order of around 0.2%. So lowering the 0.2% proof stress is to allow the metal side to yield, thereby reducing stress and warp. The method generally used to soften a metal is to lower dislocation density by annealing. However, reduction of 0.2% proof stress by anneal-softening has its limit, so that it has been difficult to keep pace with further thickness reduction of solar cell substrates. In light of this, various technologies have been proposed for improving interconnector structure and packaging, and also for collection system control (see, for example, Patent Documents 2 to 6).

On the other hand, regarding solder for use as a small joining member, solder materials obtained by mixing a granular substance into solder are known (see Patent Documents 7 and 8). Patent Document 7 teaches a technique for improving projection (bump) height horizontality after solder melting by mixing 0.01 to 5 wt% of a granular substance into pellet or elongate solder. Patent Document 8 teaches a technique that disperses metal grains in solder paste to prevent beading of the solder upon melting due to surface tension.

However, the techniques described in Patent Documents 7 and 8 both use solder as a bonding material for attaching the terminals of small electronic components like semiconductor chips to an electronic substrate. Therefore, neither of the bonding techniques taught by Patent Documents 7 and 8 envisions application as a method for bonding a solar cell and a solar cell interconnector of a length substantially the same as the length of one side of the solar cell.

For example, the ordinary practice has been to bond solar cell interconnectors at multiple locations on the front and rear surfaces of a tabular solar cell to run in parallel at predetermined spacing over a distance substantially equal to the length of one side of the solar cell. As the individual interconnectors therefore extend along and are intermittently bonded to the front and rear surfaces of solar cells over a long distance, they constantly apply stress to the solar cell.

Further, Patent Document 9 presents the results of a study on a so-called lead-free solder, namely, a tin-zinc-bismuth three-element alloy, with particular focus on mechanical strength and melting temperature characteristics.

Related Documents

Patent Documents

Patent Document 1 Unexamined Patent Publication (Kokai) No. 11-21660
Patent Document 2 Unexamined Patent Publication (Kokai) No. 2006-80217
Patent Document 3 Unexamined Patent Publication (Kokai) No. 2008-21831
Patent Document 4 Unexamined Patent Publication (Kokai) No. 2008-168339
Patent Document 5 Unexamined Patent Publication (Kokai) No. 2008-98607
Patent Document 6 Unexamined Patent Publication (Kokai) No. 2010-73445
Patent Document 7 Unexamined Patent Publication (Kokai) No. 8-174276
Patent Document 8 Unexamined Patent Publication (Kokai) No. 63-180395
Patent Document 9 Unexamined Patent Publication (Kokai) No. 9-206983

Non-patent Document

Non-patent Document 1 Yuju ENDO et al., Hitachi Cable: 2007, Vol. 26, No. 1, p15

SUMMARY

Thus, the effect of stress in solar modules has tended to increase owing to solar cell size expansion and thickness reduction and also to enlargement of interconnector size for minimizing power loss. In addition, the melting temperature of the solder for bonding solar cells and interconnectors has increased along with the so-called lead-free initiative. A need has therefore emerged to prevent solar cell warping due to the stress produced when the solar cell and interconnector are heated and cooled during bonding.

The present invention was made to solve the aforesaid problem and has as its object to provide a solar cell interconnector that reduces stress acting on the solar cell and minimizes solar cell warping and cracking.

In order to achieve the aforesaid object, the solar cell interconnector according to the present invention is characterized by comprising an electrical conductor member and a surface layer formed on at least one broad face of the electrical conductor member, which surface layer functions to reduce stress caused by difference between the coefficient of thermal expansion of the electrical conductor member and the coefficient of thermal expansion of a solar cell when the solar cell interconnector is bonded to the solar cell.

The solar cell interconnector according to the present invention has the surface layer that functions to reduce stress caused by difference between the coefficient of thermal expansion of the electrical conductor member and the coefficient of thermal expansion of a solar cell when the solar cell interconnector is bonded to the solar cell, so that warping of the solar cell due to the stress produced when the solar cell and interconnector are heated and cooled during bonding can be prevented.

One example of the surface layer used in the solar cell interconnector according to the present invention is a surface layer which is formed on at least one broad face of the electrical conductor member and which comprises solder and a granular filler of higher melting point than the solder dispersed within the solder.

When the solar cell interconnector whose surface layer has granular filler of higher melting point than solder dispersed in solder is bonded to a solar cell, the filler functions as a spacer. Therefore, with the solar cell interconnector having such a surface layer, the thickness of the solder after melt bonding becomes uniform throughout the bonding plane, so that stress produced by unevenness of solder thickness in the bonding plane can be prevented.

Moreover, the solder itself has a larger coefficient of thermal expansion than silicon and therefore imparts thermal stress to the solar cell after solidification. The coefficient of thermal expansion of the filler of higher melting point than solder is the same as or smaller than that of the conductor material used in the solder or interconnector, so that the macroscopic thermal contraction of the solder including the filler can be reduced. Thermal stress occurring between the solder and the solar cells can therefore be reduced.

Another example of the surface layer used in the solar cell interconnector according to the present invention is a surface layer which comprises Sn-base solder whose degree of undercooling $\Delta T$, defined as $\Delta T = T1 - T2$, is smaller than 25 °C; where T1 is an onset temperature representing the rise of an endothermic peak during heating at a temperature increase rate of 10 °C/min in differential scanning calorimetry and T2 is the peak temperature of an exothermic peak during cooling at a cooling rate of 10 °C/min in the aforesaid calorimetry.

This surface layer is adopted based on the idea of controlling unevenness of solder solidification temperature by controlling solder degree of undercooling $\Delta T$. Making the degree of undercooling $\Delta T$ less than 25 °C makes the solder solidification temperature after melt bonding uniform throughout the bonding plane, so that occurrence of stress caused by deviation of solder solidification temperature in the bonding plane can be prevented.

The solar cell interconnector according to the present invention functions to reduce stress occurring upon bonding to a solar cell owing to difference between the coefficient of thermal expansion of the electrical conductor member and the coefficient of thermal expansion of the solar cell, thereby making it possible to minimize warping and/or cracking of the solar cell.

## BRIEF DESCRIPTION OF DRAWINGS

FIG. 1 is an explanatory linear mounting diagram of a solar module.

FIG. 2(a) is a schematic plan view of a solar module, and FIG. 2(b) is a schematic partial side view of the solar module.

FIG. 3 is a schematic cross-sectional view along section AA' of FIG. 1.

FIG. 4 a schematic cross-sectional view along BB' of FIG. 1.

FIG. 5(a) is a schematic diagram of a first manufacturing apparatus for a solar cell interconnector, and FIG. 5(b) is a schematic diagram of a second manufacturing apparatus for a solar cell interconnector.

FIG. 6 is a schematic diagram of a third manufacturing apparatus for a solar cell interconnector.

FIG. 7 is a diagram showing an example of DSC heating/cooling measurement curves, for the case of a degree of undercooling of 25 °C or greater.

FIG. 8 is a diagram showing an example of DSC heating/cooling measurement curves, for the case of a degree of undercooling of less than 25 °C.

## DESCRIPTION OF EMBODIMENTS

In the following, embodiments of a solar cell interconnector, a method of producing the same, and a solar module are explained in detail with reference to the drawings. As used in the detailed explanation below, the term "linear mounting" means a mode of installation in which a flat conductor wire or solar cell interconnector (elongate conductor) is bonded to a semiconductor surface in a linear manner, i.e., bonded in two-dimensional linear contact, for the purpose of collecting current or forming an electrical signal circuit.

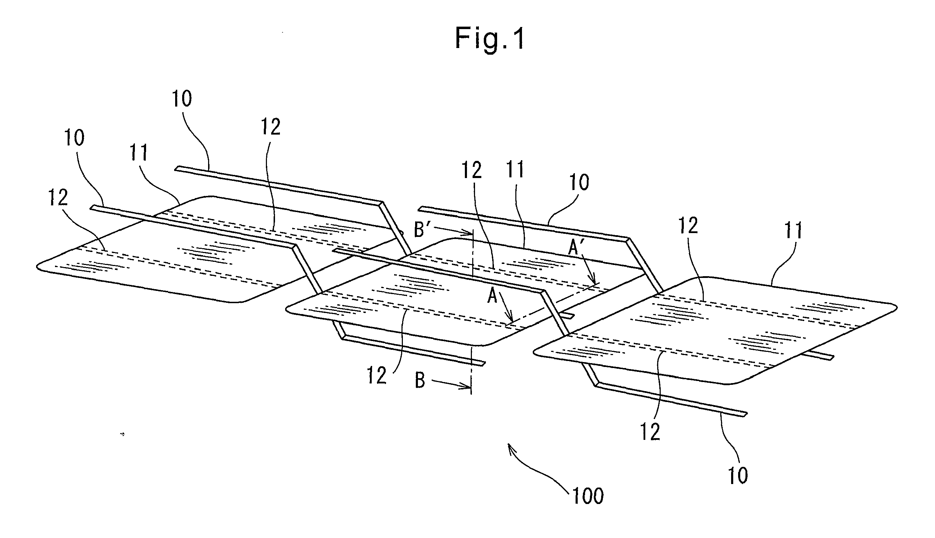

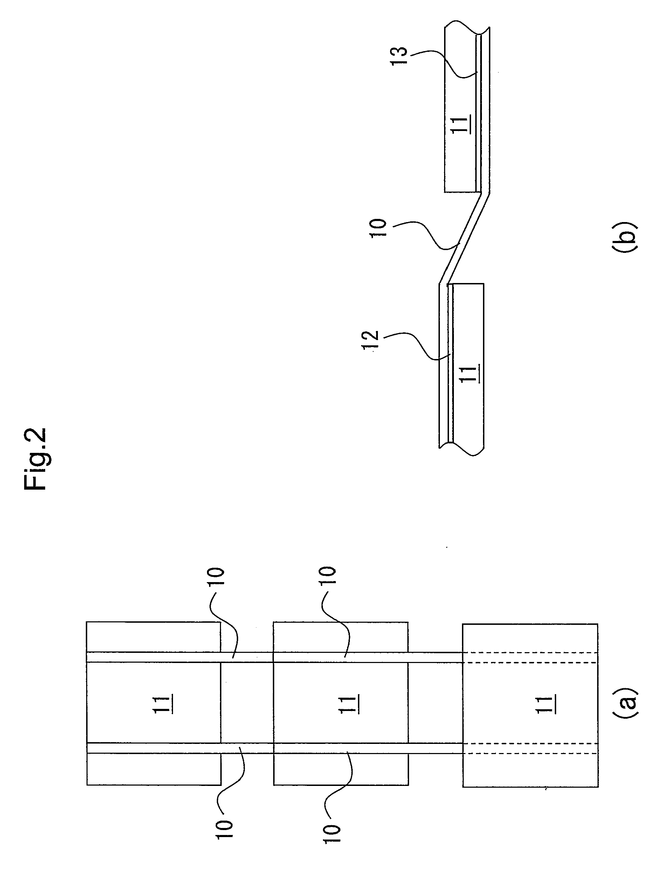

FIG. 1 is an explanatory diagram of linear mounting of solar cell interconnectors on a solar module. FIG. 2(a) is a schematic plan view of a solar module, and FIG. 2(b) is a schematic partial side view of the solar module.

A solar module 100 comprises two pairs of solar cell interconnectors 10 and three solar cells 11. Each of the two pairs of solar cell interconnectors 10 is linearly mounted on front electrodes 12 formed on the front surfaces of the solar cells 11 and rear electrodes 13 formed on the rear surfaces of the solar cells 11. The solar cell interconnectors 10 are linearly mounted through joints formed of bonding members on the surfaces of the front electrodes 12 and rear electrodes 13 of the solar cells 11. Owing to the linear mounting of the solar cell interconnectors 10 and the solar cells 11 in this manner, multiple solar cells 11 come to be connected in series. Although not illustrated in FIG. 1, FIG. 2(a) and FIG. 2(b), the solar cells 11 linearly mounted with the solar cell interconnectors 10 are provided on top with an EVA adhesion layer and protective glass and on the bottom with an EVA adhesion layer and a back film.

The electrical conductor member of a solar cell interconnector 10 is about twice as long as a solar cell 11, 1 to 3 mm wide, and 0.1 mm to 1 mm thick.

The thickness of a solder layer that forms a surface layer coated around the electrical conductor member of the solar cell interconnector 10 is about 5 $\mu$m to 80 $\mu$m, and ordinarily the maximum thickness is 40 $\mu$m and the average thickness around 20 $\mu$m.

Six-inch (150 mm square) solar cells are in wide use, and among monocrystalline types, four-inch (100 mm square) solar cells are commonly used. The thickness of the solar cell 11 is 100 $\mu$m or greater, with a thickness of around 200 $\mu$m being standard. The joint size (area, length) when solder-bonding semiconductor components therefore varies considerably.

Linear mounting of the solar cell interconnector 10 and the solar cell 11 is performed by thermocompression bonding using flux under a hot-air stream of about 500 °C for 2 to 3 seconds. The compression bonding at this time is not full-area pressure bonding but pin-like pressure bonding. In other words, the solar cell interconnector 10 linearly mounted on the solar cell 11 is pressure bonded by applying pressure from above at multiple points. For example, in the case of a six-inch (150 mm) square solar cell, the pressure bonding is performed by applying pressure at 10 points. Such a solder bonding method differs greatly from the bonding method for linearly mounting semiconductor components using reflow equipment, which spends around 40 sec at a temperature equal to or higher than the solder melting temperature, up to a maximum temperature of about 250 °C, and takes about 5 min altogether.

When the conductors bonded to the solar cell are of the same material and same size, the thermal stress acting on the solar cell is strongly affected by the solder thickness (distance between the solar cell and the conductor), the solder solidification properties, and the solder coefficient of thermal expansion. The present invention is configured to substantially solve, harmonize, and optimize these issues.

When solder is used for the joining members for linearly mounting the solar cell interconnectors 10 on the solar cell 11, the solder bonding area becomes large and long and the solder thermal properties on the surfaces of the front electrodes 12 and rear electrodes 13 should preferably be the same. This is because when the thermal properties of the joining members on the surfaces of the front electrodes 12 and rear electrodes 13 differ, warping or cracking of the solar cell is liable to occur. For example, when the thickness of the solidified solder is uneven, stress occurring in the solar cell 11 is liable to warp or crack the solar cell 11. Moreover, when the solder solidification temperature differs between the surfaces of the front electrodes 12 and rear electrodes 13, warping or cracking of the solar cell 11 is liable to occur owing to the disparity between the solidification temperatures.

In addition, when the solder thermal properties differ among the joints of the pair of solar cell interconnectors that connect the solar cells 11 in parallel, warping or cracking is liable to occur in the solar cells 11.

The solder for bonding the solar cell interconnectors 10 and solar cells 11 is therefore required to exhibit uniform thermal characteristics across single and multiple bonding surfaces.

The present invention provides a solar cell interconnector capable of bonding across single and multiple bonding surfaces with a solder exhibiting uniform thermal properties.

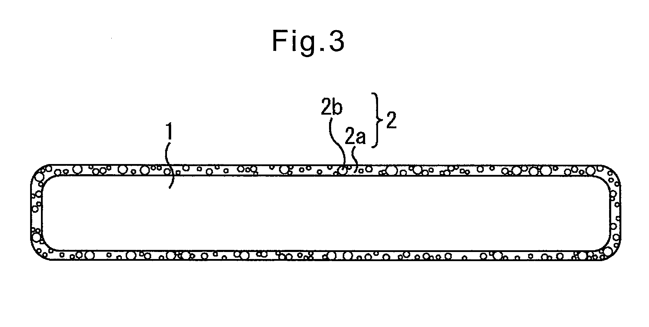

Now follows an explanation with reference to FIGs. 3 to 6 of the solar cell interconnector 10 according to a first embodiment, a method of producing the same, and a solar module.

FIG. 3 is a schematic cross-sectional view along section AA' of FIG. 1.

The solar cell interconnector 10, which is a flat conductor wire, comprises an electrical conductor member 1 and a surface layer 2. The electrical conductor member 1 is a copper wire of rounded rectangular cross-section with four rounded corners. The surface layer 2 is applied to cover the entire surface of the electrical conductor member 1. The surface layer 2 comprises solder coating 2a and filler 2b dispersed inside the solder coating 2a.

The solder coating 2a is formed of Pb-Sn eutectic solder, and the filler 2b is formed of copper granules having a higher melting point than the solder material forming the solder coating 2a. As the melting point of the filler 2b is higher than the melting point of the solder material, the filler 2b functions as a spacer between the electrical conductor member 1 and the solar cell 11. As a result, the distance between the electrical conductor member 1 and the solar cell 11 is determined by the maximum grain diameter of the filler 2b and the thickness of the surface layer 2 is maintained at a prescribed value. This means that the thickness of the solder coating 2a can be readily and accurately controlled by forming the surface layer 2 using filler 2b whose maximum grain diameter is equal to the desired value of the distance between the electrical conductor member 1 and solar cell 11.

Further, when the coefficient of thermal expansion of the incorporated filler is lower than that of the solder, the macroscopic thermal contraction of the solder including the filler can be reduced and brought closer to the coefficient of thermal expansion of the solar cell, so that the coefficient of thermal expansion of the filler is preferably equal to or lower than the coefficient of thermal expansion of the solder. Generally speaking, most metals and ceramics of higher melting point than solder have lower coefficients of thermal expansion than solder.

As pointed out later, the thickness of the solder coating 2a when the solar cell interconnector 10 is linearly mounted on the solar cell 11, i.e., the thickness of the surface layer 2, preferably has an average thickness of a value in the range of, for example, 10 $\mu$m to 40 $\mu$m. Since the thickness of the surface layer 2 after linear mounting of the solar cell interconnector 10 is determined by the maximum grain diameter of the filler 2a, the maximum grain diameter of the filler 2b is preferably a value between 10 $\mu$m and 40 $\mu$m. Moreover, the filler 2b is preferably classified to narrow the grain diameter distribution. However, coincidental inclusion at very low probability of large grains in the 10 $\mu$m to 40 $\mu$m filler 2b is acceptable. For example, where the grain distribution is modeled by normal distribution, the maximum grain diameter of the filler 2b can be the $3\sigma$ upper limit of the distribution, where $\sigma$ is standard deviation. In the case where filler of larger than desired grain diameter is removed by sifting, the filler can be sorted in order of smaller to greater grain diameter and the grain diameter located in the upper 99.85% be defined as the maximum grain diameter.

The filler 2b functions to ensure the solder quantity required for bonding. In addition, when the solder coating 2a is bonded under the condition of the electrical conductor member 1 being pressed onto the solar cell 11, the filler 2b functions as a spacer that keeps the thickness of the solder from becoming too thin and protruding laterally. Therefore, when the average thickness of the solder is too large relative to the maximum grain diameter of the filler, the solder comes to protrude laterally. On the other hand, when the maximum grain diameter of the spacer is smaller than the average thickness, a risk arises of not being able to ensure the amount of solder between the electrical conductor member 1 and solar cell 11 required for bonding. In light of this, the maximum grain diameter of the filler relative to the average thickness of the solder is preferably in the range of 50% to 100%. For sound bonding by melting and solidification, the volume fraction of the filler 2b in the surface layer 2 is preferably 5 to 30%.

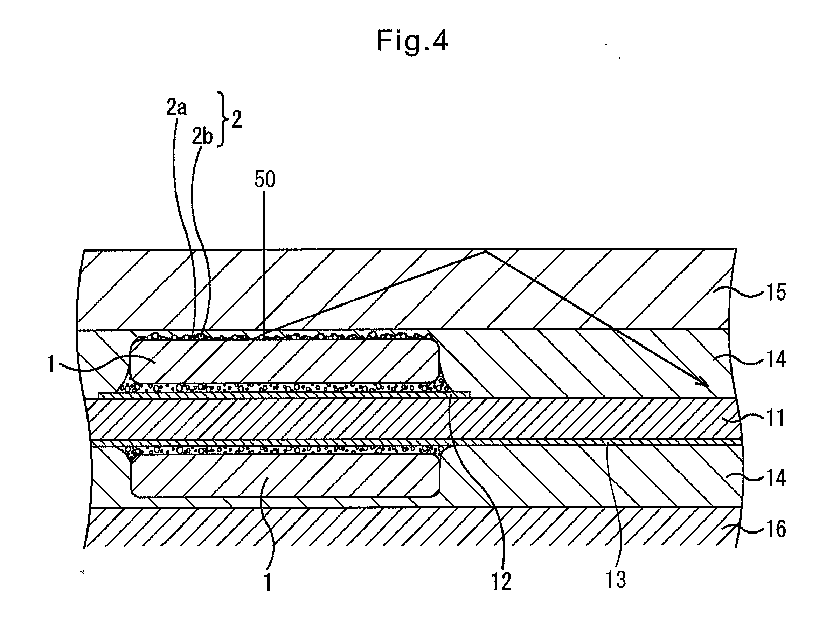

FIG. 4 a schematic cross-sectional view along BB' of FIG. 1.

The solar module 100 comprises the solar cell interconnectors 10, the solar cells 11, front electrodes 12, the rear electrodes 13, EVA adhesion layers 14, protective glass 15, and back films 16.

The solar cells 11 comprise silicon substrates and are formed on the front surfaces with the front electrodes 12 and on the rear surfaces with the rear electrodes 13. The front electrodes 12 comprise silver paste formed by baking and are formed on the light-receiving surface side. The rear electrodes 13 comprise silver and aluminum paste formed by baking and are formed on the opposite side from the light-receiving surface side.

The joints between the solar cell interconnectors 10 and the front electrodes 12 and rear electrodes 13 are formed by the solder coating 2a and filler 2b. At the joints between the solar cell interconnectors 10 and the front electrodes 12 and rear electrodes 13, the solder coating 2a functions as a joining member and the filler 2b functions as a spacer. In other words, the thickness of the joints between the solar cell interconnectors 10 and the front electrodes 12 and rear electrodes 13 is defined by the maximum grain diameter of the filler 2b.

The EVA (ethylene vinyl acetate) adhesion layers 14 are deployed on both the front and rear surfaces of the solar cells 11 to seal the solar cell interconnectors 10. The protective glass 15 is deployed to cover the EVA adhesion layers 14 on the front sides. The back films 16 are deployed to cover the EVA adhesion layers 14 on the rear sides.

A method of producing the solar cell interconnector 10 is explained next.

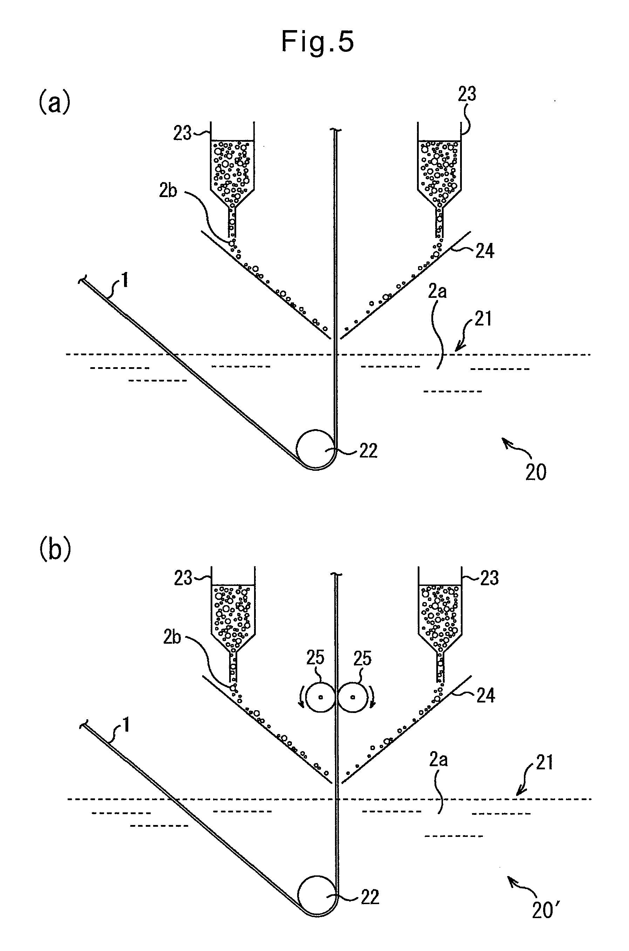

FIG. 5(a) is a schematic diagram of a first manufacturing apparatus 20 for the solar cell interconnector 10.

The first manufacturing apparatus 20, which utilizes a technique known as the hot-dip plating method, comprises a molten solder plating bath 21, a copper wire guide 22, filler hoppers 23, and filler guides 24.

The molten solder plating bath 21 holds molten solder coating 2a and supplies the solder coating 2a to the outer surface of an electrical conductor member 1 as it is passed through the molten solder plating bath 21. The copper wire guide 22 is equipped with a motor and guides the electrical conductor member 1 coated with the solder coating 2a vertically at a prescribed speed.

Each filler hopper 23 has a bin for retaining the filler 2b and a feeder for feeding the filler 2b. The bin of the filler hopper 23 is configured to receive a supply unit from an unshown filler supply unit and the feeder of the filler hoppers 23 is configured to supply filler at a set rate. The filler guides 24 are supply paths for supplying the filler 2b discharged from the feeders of the filler hoppers 23 to the electrical conductor member 1 guided vertically. In order to supply the filler 2b to the electrical conductor member 1 coated with the solder coating 2a, the lower ends of the filler guides 24 have about the same width as the width of the electrical conductor member 1.

The processing steps by which the first manufacturing apparatus 20 produces the solar cell interconnector 10 are explained next.

First, the first manufacturing apparatus 20 drives the copper wire guide 22 to pass the electrical conductor member 1 through a tube furnace (not shown) heated by charging with hydrogen-containing nitrogen gas. By this process, sometimes called bright annealing, a surface oxide layer of the copper constituting the electrical conductor member 1 is reduced by hydrogen to make the solder easily wettable. The hydrogen concentration of the tube furnace is controlled to from about 4% to 100%. When the electrical conductor member 1 is formed from a copper containing oxygen, such as tough pitch copper, in which case hydrogen embrittlement is likely to occur, it is advisable to increase the hydrogen concentration and temperature of the tube furnace.

Next, the first manufacturing apparatus 20 drives the copper wire guide 22 to pass the electrical conductor member 1 into the molten solder coating 2a of the molten solder plating bath 21. As a result, the solder coating 2a coats the outer surface of the electrical conductor member 1 passed into the molten solder plating bath 21.

Next, the first manufacturing apparatus 20 feeds the filler 2b into contact with the solder coating 2a coated onto the periphery of a region of the electrical conductor member 1 that has been moved to the exterior of the molten solder plating bath 21 by the copper wire guide 22.

Then, the first manufacturing apparatus 20 spontaneously cools and totally solidifies the solder coating 2a supplied with the filler 2b, thereby forming the surface layer 2.

FIG. 5(b) is a schematic diagram of a second manufacturing apparatus 20' for the solar cell interconnector 10. The second manufacturing apparatus 20' differs from the first manufacturing apparatus 20 in that it has pressure rollers 25 above the filler guides 24.

The processing steps by which the first manufacturing apparatus 20' produces the solar cell interconnector 10 include a step of feeding the filler 2b onto the solder coating 2a and a step which is a process of applying pressure to the electrical conductor member 1 during a step of forming the surface layer 2.

The pressure rollers 25 can regulate the solder coating 2a to a desired thickness by forcibly pressing the solder coating 2a supplied with the filler 2b onto the electrical conductor member 1.

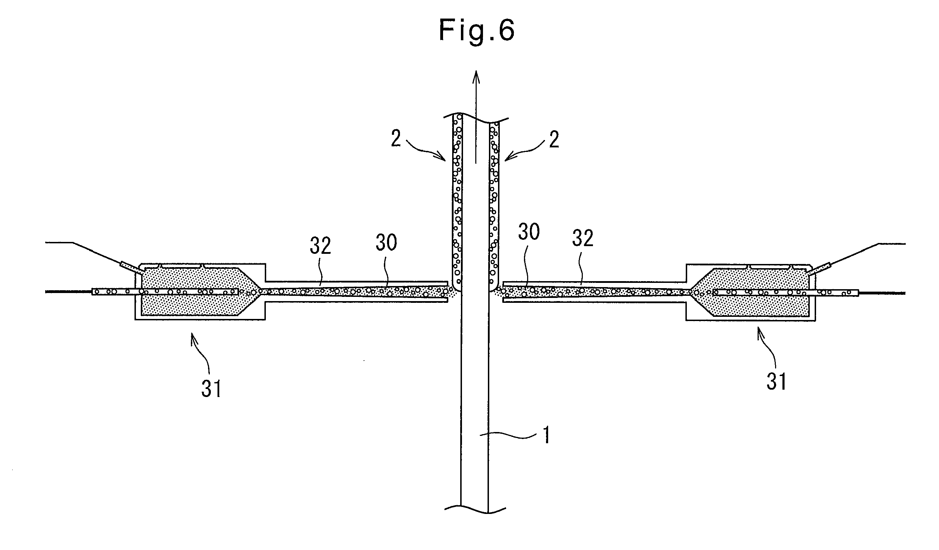

FIG. 6 is a schematic diagram of a third manufacturing apparatus 30 for a solar cell interconnector.

The third manufacturing apparatus 30, which utilizes a technique known as aerosol deposition or a technique known as cold spray, comprises mixing chambers 31 and mixture feed nozzles 32.

The mixing chambers 31 mix solder powder and filler internally. The nozzles 32 feed the mixtures of solder powder and filler mixed by the mixing chambers 31 to the electrical conductor member 1.

The processing steps by which the third manufacturing apparatus 30 produces the solar cell interconnector 10 are explained next.

First, the surface of the electrical conductor member 1 is degreased using an organic solvent such as acetone or an acid. This step removes rolling oil adhering to the surface of the electrical conductor member 1.

Next, the third manufacturing apparatus 30 uses a driver (not shown) to pass the electrical conductor member 1 in the direction of the arrow.

Then, the third manufacturing apparatus 30 feeds the mixtures of solder powder and filler mixed in the mixing chambers 31 from the mixture feed nozzles 32 onto the surface of the electrical conductor member 1 in solid phase. The feed rates of the mixtures of solder powder and filler fed from the mixture feed nozzles 32 are set higher than a predetermined rate, whereby the mixtures of solder powder and filler colliding on the surface of the electrical conductor member 1 are rapidly coated onto the electrical conductor member 1 to form the surface layer 2.

As explained in the foregoing, in the case of the solar module 100, even though the solder coating 2a is melted at the time of bonding the solar cell interconnector 10 to the front electrode 12, the filler 2b does not melt. The filler 2b therefore functions as a spacer between the electrical conductor member 1 and the front electrode 12, whereby the distance between the electrical conductor member 1 and the respective front and rear electrodes 12 and 13 comes to be determined by the maximum grain diameter of the filler 2b so as to maintain the thickness of the surface layer 2 at an appropriate set value.

The solar cell interconnectors 10 and solar cells 11 are bonded by the solder coating 2a and filler 2b forming the surface layer 2. At this time, the electrical conductor member 1 fulfills a function of retaining the solder coating 2a and filler 2b at the time of melt bonding. In other words, when the electrical conductor member 1 and the solar cell 11 are bonded with solder, the electrical conductor member 1 and solar cell 11 can be easily aligned because the electrical conductor member 1 and solder coating 2a are strongly bonded beforehand. Moreover, in the transient state of wetting and spreading of the solder coating 2a at the interface with the solar cell 11, the solder and filler are retained near the flat wire because the electrical conductor member 1 is already wetted by the solder coating 2a.

When the solar cell interconnectors 10 are soldered to the front electrodes 12 and rear electrodes 13 of the solar cell 11, a sufficient amount of solder is preferably supplied, but when more solder than necessary is supplied, the power generation efficiency is degraded. This loss of power generation efficiency is caused by reduction of light-receiving area owing to excessively supplied solder covering the light-receiving surface and a rise in electrical resistance value owing to an increase in the amount of high-resistivity solder. In addition, the height of the solar cell interconnector 10 increases with the amount of the solder and the larger shadow cast on the light-receiving surface by a taller solar cell interconnector 10 lowers the power generation efficiency of the solar cell 11. On the other hand, supply of too little solder makes it difficult to supply the solder evenly and therefore diminishes the mitigating effect on the thermal expansion difference between the copper of the wire and the silicon of the solar cell realized by interposing soft solder. The resulting increase in stress and thermal strain exacerbates warping and cracking of the solar cell.

In the case of the solar module 100, the height of the joints can be established as desired because the distance between the electrical conductor members 1 and the front electrodes 12 and rear electrodes 13 is determined by the maximum grain diameter of the filler 2b.

Viewed comprehensively, defining the thickness of the surface layer 2 at a value in the range of 10 $\mu$m to 40 $\mu$m makes it possible to inhibit degradation of solar module 100 power generation efficiency and minimize warping and cracking of the solar cells 11.

Further, in the case of the solar module 100, the surface layer 2 is also formed on the broad face on the upper side of the solar cell interconnectors 10 mounted on the front surface of the solar cell 11. When the filler 2b is dispersed in the solder coating 2a of both broad faces of the electrical conductor members 1, part of the solder coating 2a fed to the top surfaces of the electrical conductor members 1 moves to the bottom surfaces of the electrical conductor members 1 under the action of gravity and surface tension. As a result, irregularities attributable to the presence of the filler 2b appear on the surface layer 2 on the top surfaces not subject to bonding with the front electrodes 12. Sunlight 50 incident on the front surface (light-receiving surface) side of the solar cell 11 is diffusely reflected by the irregularities of the broad faces of the top sides of the solar cell interconnectors 10, and some of it enters the solar cell 11 after being reflected again at the interface between the EVA adhesion layer 14 and protective glass 15 and at the interface between the protective glass 15 and the atmosphere. As a result, light ordinarily lost by reflection from the solar cell interconnectors 10 can be used as power to realize a further improvement in the power generation efficiency of the solar module.

Modifications of the solar cell interconnector 10 according to the first embodiment are explained next.

Although the case where the solar cell interconnector 10 is linearly mounted on the solar module 100 is explained in the foregoing, the solar cell interconnector 10 can also be applied as a flat conductor wire in a semiconductor packaging material used in LSIs, LEDs and other small semiconductor devices.

While the electrical conductor member 1 of the solar cell interconnector 10 is a copper wire, it can instead use a copper alloy, aluminum, silver or other good electrical conducting material. Further, although the solar cell interconnector 10 has the entire front surface of the electrical conductor member 1 covered with the surface layer 2, the surface layer 2 can instead be formed to cover either or both of the broad faces which are the surfaces including the wide side of the width in the cross-section orthogonal to the longitudinal direction of the electrical conductor member 1. In other words, the surface layer 2 can be formed only on one or both of the broad faces of the electrical conductor member 1. The solar cell interconnector 10 having the surface layer 2 on only one broad face of the electrical conductor member 1 is applied to a back-contact solar module or the like.

The solar cell interconnector 10 of such type can be formed using the third manufacturing apparatus 30 by operating only one of the mixing chamber 31 and nozzle 32 pairs deployed relative to the opposite broad faces of the electrical conductor member 1.

Further, the solar cell interconnector 10 having the surface layer 2 on only one surface of the electrical conductor member 1 can also be produced by applying and hardening on the electrical conductor member 1 a solder paste containing the filler 2b. With this production method, the solder coating 2a is heated and melted to wet the electrical conductor member 1 and the solder coating 2a and thereby form a reaction phase at the interface of the electrical conductor member 1 and solder coating 2a, so that a more suitable solar cell interconnector 10 can be produced.

Although in the solar cell interconnector 10, the solder coating 2a is formed using Pb-Sn eutectic solder, it can instead be formed using some other solder material such as an Sn-Ag-Cu-base lead-free solder material.

Further, although in the solar cell interconnector 10, the filler 2b is copper granules, it can be granules formed of another material of higher melting point than solder material. When aluminum, silver or other metal is adopted as the material of the filler 2b, the electrical resistance value of the filler 2b becomes lower than the electrical resistance value of the solder coating 2a, just as it does in the case of adopting copper for the filler 2b. The electrical resistance value of the surface layer 2 can therefore be lowered by adopting a metal as the material of the filler 2b. Taking the resistivity into account, silver, copper and aluminum are preferable in the order mentioned. On the other hand, taking difference in coefficient of thermal expansion relative to silicon into account, copper, silver and aluminum are preferable in the order mentioned. More specifically, a comparison of copper and silver shows that silver is superior to copper in the aspect of electrical conductivity while copper is superior to silver in the aspect of price. A comparison of copper and aluminum shows that copper is superior to aluminum in the aspect of electrical conductivity while aluminum is superior to copper in the aspect of price.

As the filler 2b can be used stainless steel, alumina, silica and other materials of smaller coefficient of thermal expansion than the solder material. In this case, after the solar cell interconnector 10 is linearly mounted on the solar module, the surface layer 2 functions as a stress relief layer. The coefficient of thermal expansion of silica is very small, so that when silica is adopted as the filler 2b, the difference in coefficient of thermal expansion of the solder interfacial phase between the electrical conductor member and silicon substrate can be reduced.

Moreover, it is possible to adopt as the material of the filler 2b a ceramic that has been surface-coated with an active metal such as titanium, molybdenum, manganese or tungsten. In this case, interfacial reaction between the ceramic and the metal is promoted to cause coating with an active metal that enhances bondability of the ceramic and metal, so that wettability of the filler 2b and solder coating 2a is improved. The active metal is coated onto the ceramic by vapor deposition, sputtering, CVD or other gas phase process. For example, coating with a titanium layer on the order of 0.1 $\mu$m is possible by the pyrosol process, which is one type of CVD process. Coating with active metal can also be applied in the case of stainless steel, aluminum and other metal fillers whose wettability with solder is poor.

For the purpose of facilitating alignment at the time of bonding the electrical conductor member 1 and solar cell 11, it suffices to coat the surface layer 2 on the electrical conductor member 1, but it is also possible for the reaction layer to be formed prior to the bonding to the solar cell 11. When a reaction layer is present on the surface layer 2 in the transient state of bonding the solar cell interconnector 10 to the solar cell 11, the solder coating 2a wets the electrical conductor member 1 before wetting the solar cell 11. Therefore, the solar cell interconnector 10 having the reaction layer formed on the surface layer 2 can keep the solder coating 2a and filler 2b near the electrical conductor member 1 when the solar cell interconnector 10 is bonded to the solar cell 11.

In the case where the electrical conductor member 1 is made of copper and the solder coating 2a is made of Pb-Sn eutectic solder or other solder containing much tin, the reaction layer is preferably $Cu_6Sn_5$ formed at the interface of the electrical conductor member 1 and solder coating 2a. The thickness of the reaction layer composed of $Cu_6Sn_5$ can be thin. Moreover, the reaction layer composed of $Cu_6Sn_5$ need not be distributed throughout the interface between the electrical conductor member 1 and the solder coating 2a. However, when the average thickness of the reaction layer composed of $Cu_6Sn_5$ exceeds 5 $\mu$m, cracks tend to form at the interface of the electrical conductor member 1 and solder coating 2a. As the solar cell interconnector 10 is desirably soft, it is undesirable for the average thickness of the reaction layer composed of $Cu_6Sn_5$ to exceed 5 $\mu$m.

Moreover, among the processing steps for producing the solar cell interconnector 10 using the first manufacturing apparatus 20, the step of passing the electrical conductor member 1 through the tube furnace can be omitted. Also, the atmosphere of the tube furnace can be solely argon containing no hydrogen. Further, instead of performing bright annealing, it is possible to adopt the method of coating with flux followed by hot-dip plating.

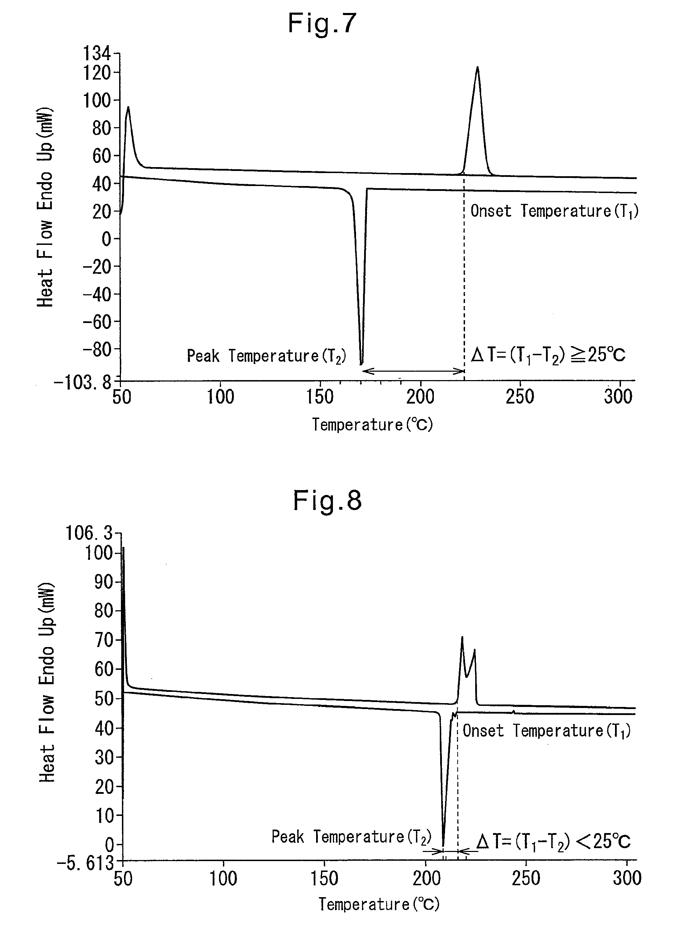

A solar cell interconnector according to a second embodiment and a method of producing the same are explained next with reference to FIGs. 7 and 8.

The inventors of the present invention ascertained that unevenness in solder solidification temperature inside the joint of the solar cell interconnector 10 and solar cell 11 has a very considerable effect on warping and cracking of the solar cell 11. Specifically, it was concluded that stress caused by unevenness in solder solidification temperature within the bonding plane of the linearly mounted solar cell interconnector 10 and the solar cell 11 causes warping and cracking of the solar cell 11. From this it follows that warping and cracking of the solar cell 11 can be inhibited by keeping the unevenness of joint solder solidification temperature within a predetermined range so as to reduce the stress caused by differences in solder solidification temperature. Moreover, reducing the degree of undercooling of the solder is an ultimately simple and controllable method for converging the joint solidification temperature on a prescribed temperature.

Patent Document 9 describes use of a differential scanning calorimeter (DSC) to determine how solder bonding is related to the number of endothermic peaks in the melting temperature characteristics. Specifically, Patent Document 9 points out that a solder exhibiting only a single endothermic peak in the DSC curve is suitable for printed circuit board packaging and a solder exhibiting two endothermic peaks in the DSC curve is advantageous in bonding using a soldering iron. Thus, Patent Document 9 discloses use of DSC measurement results for evaluating solder melting temperature characteristics, but it does not describe control of solder solidification temperature unevenness based on DSC measurement results.

As termed in this specification, degree of undercooling means difference between the solidification temperature of a substance in an actual cooling process and the solidification temperature of the substance in thermal equilibrium. Degree of undercooling depends on cooling rate and is large when cooling rate is high. In this specification, as degree of undercooling is used the degree of undercooling for evaluating degree of undercooling at the cooling rate of 10 °C/min generally and frequently performed in thermal analysis of solder materials. Specifically, degree of undercooling is defined as the difference ($\Delta T = T1 - T2$) that appears in a DSC curve measured by differential scanning calorimetry between an onset temperature (T1) in a 10 °C/min temperature increasing process and a peak temperature (T2) in a 10 °C/min cooling process.

The onset temperature (T1) representing rise of an endothermic peak in a temperature increasing process corresponds to the solidus temperature of JIS Z3198-1. On the other hand, the peak temperature (T2) of an exothermic peak in a cooling process is the temperature when the exothermic value in the cooling process reaches maximum value. Therefore, when the exothermic value in the cooling process has multiple peaks, the temperature corresponding to the maximum peak value is T2. The DSC curve can be measured either for the state of discrete solder or the state of solder plated on a copper core material or other electrical conductor of a solar cell interconnector.

FIG. 7 is an example of a DSC curve whose degree of undercooling $\Delta T$ is 25 °C or greater. FIG. 8 is an example of a DSC curve whose degree of undercooling $\Delta T$ is less than 25 °C.

The degree of undercooling of an Sn-base solder is ordinarily 30 °C or greater. Moreover, in the case of a solder whose degree of undercooling is 30 °C or greater, the solidification temperature varies inside the solder. Therefore, when a solder whose degree of undercooling is 30 °C or greater is used as a material for bonding a solar cell interconnector and a solar cell, stress occurs owing to the unevenness of the solidification temperature inside the solder. This stress is liable to exacerbate warping and/or cracking of the solar cell. Lowering the degree of undercooling of the solder to less than 25 °C is effective for minimizing unevenness of the solidification temperature inside the solder. In addition, the degree of undercooling of the solder is preferably 15 °C or less. The reason for lowering the degree of undercooling of the solder to less than 25 °C is that when the degree of undercooling becomes 25 °C or greater, the difference in solidification temperature inside the solder becomes 10 °C or greater and the stress caused by the solidification temperature difference exacerbates warping and/or cracking of the solar cell. In this specification, solidification temperature unevenness is said to be great when the solidification temperature difference inside the solder is greater than 10 °C. As pointed out later, when the degree of undercooling of the solder is less than 25 °C, the solidification temperature difference inside the solder is within 10 °C and the effect of stress caused by solidification temperature difference also decreases, meaning that it is necessary for the degree of undercooling to be less than 25 °C.

An example of a solder used for the solar cell interconnector according to the second embodiment is an Sn-base solder containing, in mass%, at least one of Zn, Mg, Ti, Co, Zr and Be at not less than 0.001% and not greater than 2%. The reason for the content of at least one of Zn, Mg, Ti, Co, Zr and Be being not less than 0.001% is that an effect of lowering the degree of undercooling cannot be adequately obtained at a content of less than 0.001 mass%. The reason for the content of at least one of Zn, Mg, Ti, Co, Zr and Be being not greater than 2%, is that at a content greater than 2 mass% the solder is liable to become hard and lose solderability. Further, the content of at least one of Zn, Mg, Ti, Co, Zr and Be of the Sn-base solder is preferably not less than 0.01 mass% and not greater than 1 mass%.

When the solder contains Zn, the Zn enters into solid solution in the solder and enhances the solder strength. When the solder contains Mg, the Mg acts as a deoxidizer and reduces the oxygen concentration inside the solder. Mg also thins the solder surface oxide film. When the solder contains Ti, the Ti finely disperses inside the solder to act as a precipitation hardener. When the solder contains Co, the Co substitutes for Cu in $Cu_6Sn_5$ formed at the interface and reduces the internal stress of the compound.

When differential scanning calorimetry is performed on an Sn-base solder at a heating/cooling rate of 10 °C/min, absolute thermal equilibrium cannot be achieved, so that the solidification temperature (T2) becomes a temperature lower than the melting onset temperature (T1) by 0.1 °C or greater. The lower limit of the degree of undercooling is therefore practically 0.1 °C. The degree of undercooling of a solder may vary with heating or cooling notwithstanding that the additive contents are the same substances. However, by measuring the degree of undercooling of the unbonded portion of the solar cell interconnector in the state bonded to the solar cell, it becomes possible to measure the degree of undercooling of the solar cell interconnector before it is bonded to the solar cell.

As the composition of an example of the solder used for the solar cell interconnector according to the second embodiment, the mass% of Sn is preferably 60% or greater. This is because when the mass% of Sn is less than 60%, it is hard to realize the effect of inhibiting warping and/or cracking of the cell even if the degree of undercooling is less than 25 °C. This is because a correlation between degree of undercooling and solidification temperature can be realized in a metal and alloy dominated by Sn.

In one example of the solder used for the solar cell interconnector according to the second embodiment, Ag is preferably contained, in mass%, at not less than 0.1% and not greater than 4%. Addition of Ag lowers the solder melting point to enable reduction of thermal strain occurring during mounting, and also improves the reliability of the bonding by improving the mechanical properties of the solder. When the Ag content is less than 0.1%, the aforesaid effects are hard to achieve. When the Ag content exceeds 4%, the reliability of the joint is liable to diminish owing to formation of coarse $Ag_3Sn$.

In another example of the solder used for the solar cell interconnector according to the second embodiment, Cu is preferably contained, in mass%, at not less than 0.1% and not greater than 1.5%. Similarly to addition of Ag, addition of Cu to an Sn-base solder lowers the solder melting point, and also enhances wettability. When the Cu content is less than 0.1%, the aforesaid effects are hard to achieve. When the Cu content exceeds 1.5%, the reliability of the joint is liable to diminish owing to formation of a coarse Sn-Cu-base intermetallic compound.

In another example of the solder used for the solar cell interconnector according to the second embodiment, at least one of Fe and Ni is preferably additionally contained, in mass%, at not less than 0.001% and not greater than 0.2%. This lowers the degree of undercooling and enables improvement of bonding reliability by enhancing the fatigue properties of the solder. When the content of at least one of Fe and Ni is less than 0.001%, the aforesaid effects are hard to achieve. When the content of at least one of Fe and Ni exceeds 0.2%, there is a risk of the wettability and bonding strength of the solder being degraded. In an example of a solder of low degree of undercooling, the mass% of at least one of Fe and Ni is not less than 0.01% and not greater than 0.1%.

Other examples of the solder used for the solar cell interconnector according to the second embodiment can be either lead-free solder or leaded solder. When the example of the solder according to the second embodiment is a lead-free solder, it suffices to be an Sn-Ag-base, Sn-Cu-base or Sn-Ag-Cu-base solder of nearly eutectic composition. On the other hand, when the example of the solder according to the second embodiment is leaded solder, lead content expressed in mass% is preferably around the eutectic region at not less than 30% and not greater than 40%. Further, lead content is more preferably not less than 35 mass% and not greater than 40 mass%. This is because when lead content is near the eutectic point, the melting point of the solder can be lowered and residual stress can be reduced.

The solar cell interconnector according to the second embodiment is an electrical conductor such as a wire, a tape material or other conductor whose surface is partially or totally coated with one of the aforesaid solders. In the production of such a solar cell interconnector, an electrical conductor for constituting the core is immersed in a molten plating material using a plating bath having a composition like that of the aforesaid Sn-base solder. This process makes it possible to obtain a solar cell interconnector whose conductor surface is at least partially coated with Sn-base solder. Although the amount of Sn-base solder coated onto the conductor is not particularly limited, it is generally preferable to apply the Sn-base solder coating to an approximate thickness of not less than 5 μm and not greater than 80 μm.

A Cu-base material is generally used as the electrical conductor constituting the core of the solar cell interconnector. The effects of the present invention can be realized irrespective of the type of Cu material of the core, but by using of a core material that has been orientation-controlled to orient the <100> direction in the longitudinal direction of the core, it becomes additionally possible to prevent cell warping and/or cracking, in combination with the effects of the present invention.

The first and second embodiments were explained in the foregoing. By combining the first/second embodiment and the second embodiment, a joint can be formed that is of uniform thickness and melting point throughout the bonding plane.

EXAMPLES

Concrete examples of the present invention are explained below.

Example 1

In the present example, an interconnector (flat conductor wire) having a surface layer of a solder coating containing stainless steel filler was fabricated. As a copper core was used a flat copper wire obtained by rolling a Φ1.5 mm tough pitch-base round wire to 0.2 mm thickness, 2 mm width. This copper wire was passed through a heated 600 °C tube furnace under a stream of nitrogen containing 40% hydrogen, and with the copper wire exit side of the tube furnace inserted in a hot-dip solder plating bath, the copper wire was fed out to be hot-dip plated. A solder material of Sn - 3.0 wt% Ag - 0.5 wt% Cu was used, and the temperature of the hot-dip plating bath was set at 300 °C. The copper wire having passed through the hot-dip plating bath was fed out vertically using a copper wire guide, but a drawing die with an angular hole measuring 0.3 mm in thickness and 2.4 mm in width was installed at the surface of the plating bath and the copper wire was passed upward through this hole. The copper wire immediately after passing through the drawing die carried molten solder, but the solder cooled and solidified with upward movement. The thickness of the solder coating a copper wire passed at 0.5 mm/min averaged 25 $\mu$m per side in the direction perpendicular to the wire thickness, and this was used for comparison. It was designated sample A.

On the other hand, feeders for supplying the stainless steel filler were installed immediately above the drawing die, the stainless steel filler was brought into contact with the surface of the solder in molten state, and the stainless steel filler was pressed into the solder plating layer by immediately following pressure rollers to fabricate the interconnector. The stainless steel filler was classified using a sieve, and a filler of a maximum grain diameter of 20 $\mu$m was used. As a result of passing the copper wire at the rate of 0.5 mm/min, the average solder thickness was 25 $\mu$m and the volume fraction of the stainless steel filler in the solder was 10%. The interconnector fabricated in this manner was designated sample B. $Cu_6Sn_5$ of an average thickness of 1 $\mu$m was formed at the solder-copper interface of both sample A and sample B.

Pairs of the aforesaid interconnectors were mounted on respective electrodes formed on 200 $\mu$m thick, 150 mm square solar cells by baking two 3 mm wide parallel strips of silver paste applied under a set pressure. During the mounting, the bonding was performed by melting the solder at a temperature equal to or higher than the solder melting point and lower than the melting point of the stainless steel filler. The lateral length of solder protruding from the interconnector and the warping of the solar cell were measured.

Cell warping occurred as bowing with the side bonded to the interconnectors on the inside and in the longitudinal direction of the interconnectors. Specifically, the warping occurred as the result of thermal stress during cooling following bonding to the electrodes on the silicon cell with concurrent solidification of the solder, and arose because the coefficients of thermal expansion of the conductor copper and the solder were smaller than the coefficient of thermal expansion of the silicon. The amount of cell warping was determined with the warped cell facing downward on a horizontal surface by measuring the distance between the horizontal surface at the cell center region and the cell.

In the case of sample A, solder locally protruded laterally from the copper wires, reaching an average width of 0.2 mm and a maximum width of 1 mm per side, and the solder protruding from the electrodes spread as far as the solar cell light-receiving surface. In contrast, in the case of sample B, the amount of solder lateral protrusion stayed within an average of 0.05 mm and a maximum of 0.1 mm per side.

A comparison of cross-sections of the copper wires in samples A and B showed that in the case of sample B the distance between the solar cell electrode and the copper wire was maintained at an average of 25 $\mu$m by the stainless steel filler and no copper wetting and spreading in the lateral direction. In contrast, sample A had local regions between the copper wire and the electrode where substantially no solder was present, and solder saliently protruded sideways at these regions.

Moreover, warping of the solar cell using sample A incorporating no stainless steel filler was 3 mm toward the side mounted with the interconnector, while in the solar cell mounted with interconnectors of sample B incorporating stainless steel filler, warping was 0.8 mm. The reason for this is considered to be as follows. First, the solder solidification contraction was small because the stainless steel filler was in solid phase during solder reflow. Next, the thermal contraction after solidification was small because the coefficient of thermal expansion of stainless steel is small. In addition, thermal strain owing to the difference in coefficient of thermal expansion between copper and silicon was mitigated because the interval between the interconnector and the solar cell was maintained constant.

Example 2

In the present example, an interconnector (flat conductor wire) having a surface layer of a solder coating containing copper filler was fabricated. As a copper core was used a flat copper wire obtained by rolling a $\Phi1.5$ mm tough pitch-base round wire to 0.2 mm thickness, 2 mm width. This copper wire was passed through a heated tube furnace under a stream of nitrogen containing 40% hydrogen, and with the copper wire exit side of the tube furnace inserted in a hot-dip solder plating bath, the copper wire was fed out to be hot-dip plated. A solder material of Sn - 1.2 wt% Ag - 0.5 wt% Cu - 0.05 wt% Ni alloy was used, and the copper wire passed through a hot-dip plating bath maintained at 250 °C was fed out vertically and conveyed upward. The copper wire immediately after exiting the bath carried molten solder, but the solder cooled and solidified with upward movement.

As regards copper filler supply, feeders for supplying the copper filler were installed, the filler was brought into contact with the surface of the solder in molten state, and the copper filler was pressed into the solder plating layer by immediately following pressure rollers. The copper filler was classified using a sieve, and fillers of five maximum grain diameter levels of 5 $\mu$m to 50 $\mu$m were used. The volume fraction of the copper filler in the solder was 20%, and the feeder feed rate, tube furnace temperature and copper wire running velocity were regulated to control the solder thickness to the maximum grain diameter of the copper filler, thereby fabricating interconnectors having a surface layer containing copper filler. Interconnectors fabricated in this manner were designated samples C to J. Further, an interconnector with a solder thickness of 40 $\mu$m per side containing no copper filler was fabricated as a comparative material. The interconnector fabricated in this manner was designated sample K. $Cu_6Sn_5$ of an average thickness of 0.5 $\mu$m was formed at the solder-copper interface of all samples.

Pairs of the aforesaid interconnectors were mounted on respective electrodes formed on 190 $\mu$m thick, 170 mm square solar cells by baking two 3 mm x 5 mm sized parallel strips of silver paste applied under a set pressure. During the mounting, the bonding was performed by melting the solder at a temperature equal to or higher than the solder melting point and lower than the melting point of the copper filler. The mounted interconnectors had the same length (170 mm) as the solar cell and were mounted along the center lines of the electrodes on the solar cell. The solar cell and the interconnectors were bonded at an offset of 5 mm in the mounting longitudinal direction. After bounding, solder protruding from the interconnector was observed and the warping and cracking condition of the solar cell was measured.

Cell warping occurred as bowing with the side bonded to the interconnectors on the inside and in the longitudinal direction of the interconnector. Specifically, the warping occurred as the result of thermal stress during cooling following bonding to the electrodes on the silicon cell with concurrent solidification of the solder, and arose because the coefficients of thermal expansion of the conductor copper and the solder were smaller than the coefficient of thermal expansion of the silicon. The amount of cell warping was determined with the warped cell facing downward on a horizontal surface by measuring the distance between the horizontal surface at the cell center region and the cell.

The results are shown in Table 1 below.

Table 1

| Sample | Filler max grain diameter ($\mu$m) | Solder protrusion | Cell warping (mm) | Cracking evaluation | Remark |
|---|---|---|---|---|---|
| C | 5 | $\Delta$ | 4.0 | $\Delta$ | Example |
| D | 8 | $\Delta$ | 3.0 | $\Delta$ | Example |
| E | 10 | $\bigcirc$ | 2.0 | $\bigcirc$ | Example |
| F | 20 | $\bigcirc$ | 1.0 | $\bigcirc$ | Example |
| G | 30 | $\bigcirc$ | 1.0 | $\bigcirc$ | Example |
| H | 40 | $\bigcirc$ | 1.5 | $\bigcirc$ | Example |
| I | 42 | $\Delta$ | 2.8 | $\Delta$ | Example |
| J | 50 | $\Delta$ | 3.8 | $\Delta$ | Example |
| K | - | X | 4.6 | X | Comparative example |

Solder protrusion was evaluated from the degree of wetting and spreading in the direction perpendicular to the longitudinal direction of the interconnector after interconnector mounting. Symbol $\bigcirc$ means that the electrode and solder were wetted and a fillet was formed but is a condition where lateral wetting and spreading were uniform and confined to the width of the silver electrode. Symbol Δ is a condition where solder protruded locally but its maximum lateral spread was confined within 3 mm electrode width. Symbol X is a case where solder protruded locally and spread beyond the electrode to as far as the light-receiving surface of the solar cell.

Further, cracking was evaluated as follows from observation of a polished cross-section of the interconnector and solar cell with a light microscope. Symbol ○ is a case where no cracking was observed, symbol Δ is a case where occurrence of cracking was observed locally, and symbol X is a case where major cracking occurred and partial detachment of the solar cell and interconnector occurred.

In samples C, D, I and J, solder was observed to spread to near the 3 mm electrode width and protrusion from the electrode was observed in all of the interconnectors. On the other hand, in the interconnector with no copper filler, the solder spread and reached as far as the light-receiving surface of the solar cell. This shows the effect of the copper filler. The effect was particularly good when the thickness of the surface layer was 10 μm to 40 μm. The moderate protrusion in the samples with small copper fillers is thought to be due to flow of the copper filler during bonding. Further, although lateral wetting and spreading tended to occur with thick solder, the presence of the copper filler appears to have counteracted this tendency.

The amount of warping was dependent on the maximum grain diameter of the copper filler, and sound bonding with little warping and no observable cracking was possible when the maximum grain diameter of the copper filler was 10 μm to 40 μm. When the maximum grain diameter of the copper filler was less than 10 μm, the distance between the copper wire and the silicon was too small to enable mitigation of stress caused by difference in thermal contraction after reflow, so that cracking occurred in the solder and solar cell. However, from the fact that the cracking stopped in the vicinity of the copper filler, it was concluded that crack development could be inhibited.

On the other hand, when the maximum grain diameter of the copper filler was greater than 40 μm, cracking occurred in the solar cell because the stress caused by difference in thermal contraction after reflow increased owing to the greater thickness of the solder added to the copper wire. In the particular case of sample K not added with copper filler, detachment occurred at the interface between the solar cell and interconnector. This is thought to be because the stress acting on the interface was greatest in this case.

Next, electrical resistance value was measured between the ends of interconnectors protruding 5 mm from the solar cell and exposed electrode surfaces not bonded to the interconnectors. The result was that the electrical resistance value across a bonded region on which an interconnector having a surface layer containing copper filler was mounted was lower than the electrical resistance value across a bonded region mounted without including copper filler. This was because copper is a better conductor than solder, and attributable to the electrical resistance value reducing effect of the bonded region owing to the flow of current also through the copper filler. Another reason for the higher electrical resistance value of the interconnector not added with copper filler was that detachment of the bonded region hindered current flow. The electrical resistance value of the bonded region was lowest when the thickness of the surface layer was 10 μm to 40 μm, but this was also because the joint was sound thanks to the minimization of cracking by the stress mitigating mechanism. In other words, the reduction of the electrical resistance value of the surface layer with the use of the copper filler was unmistakable.

When the thickness of the solder added to the copper wire is enlarged, the shadow of obliquely incident sunlight becomes long. As shielding the light-receiving surface from light lowers the power generation efficiency of the solar module, the optimum range of the maximum grain diameter of the copper filler can be said to be between 10 μm and 40 μm also in view of this point.

Example 3

In the present example, fabrication of interconnectors (flat conductor wires) having surface layers of solder coatings respectively using aluminum, silver, nickel, alumina and silica as filler material was conducted by the hot-dip plating method and aerosol method. As a copper core was used a flat copper wire obtained by rolling a Φ1.5 mm tough pitch-base round wire to 0.15 mm thickness, 2 mm width.

Fabrication of samples by the hot-dip plating method was as follows. The copper wire was passed through a heated tube furnace under a stream of nitrogen containing 40% hydrogen, and with the copper wire exit side of the tube furnace inserted in a hot-dip solder plating bath, the copper wire was fed out to be hot-dip plated. A solder material of Sn - 3.0 wt% Ag - 0.5 wt% Cu alloy was used, and the copper wire passed through a hot-dip plating bath maintained at 250 °C was fed out vertically using a copper wire guide and conveyed upward. The copper wire immediately after exiting the bath carried molten solder, but the solder cooled and solidified with upward movement.

As regards copper filler supply, feeders for supplying the filler were installed, the filler was brought into contact with the surface of the solder in molten state, and the filler was pressed into the solder plating layer by immediately following pressure rollers. The filler was classified using a sieve, and a filler of a maximum grain diameter of 25 μm was used. As the alumina filler and silica filler were used ones vapor deposition-coated with about 0.05 μm of Ti. The volume fraction of the filler in the solder was 15%, and the feeder feed rate, tube furnace temperature and copper wire running velocity were regulated to control the solder thickness to 30 $\mu$m, thereby fabricating interconnectors having surface layers containing the respective fillers. The interconnectors fabricated in this manner were designated samples L to P. Further, an interconnector with a solder thickness of 30 $\mu$m per side containing no filler was fabricated as a comparative material. The interconnector fabricated in this manner was designated sample Q.

Fabrication of a sample by the aerosol method was as follows. The copper core used was the same as that used in the hot-dip plating, but it was degreased with acetone before applying the solder coating. As the alumina filler was used one whose grain diameter was the same as the hot-dip plating alumina filler before coating with Ti. As the solder was used one that had the same composition as the solder used in the hot-dip plating and a granularity of 35 $\mu$m. A mixture of these powders prepared to make the volume fraction of the alumina filler 15% was used as an aerosol jetting material.

Nitrogen gas was used as working gas during coating by aerosol deposition, and films were deposited on both surfaces of the copper wire, one surface at a time, to a film thickness of 35 $\mu$m per side, at a working temperature of 150 °C, pressure of 2MPa, and copper wire running velocity of 100 mm/s. The interconnector fabricated in this manner was designated sample R. Further, an interconnector using a solder material containing no alumina was fabricated as a comparative material. The interconnector fabricated in this manner was designated sample S.

Pairs of the aforesaid interconnectors were mounted on respective electrodes formed on 190 $\mu$m thick, 170 mm square solar cells by baking two 3 mm x 5 mm sized parallel strips of silver paste applied under a set pressure. During the mounting, the bonding was performed by melting the solder at a temperature equal to or higher than the solder melting point and lower than the melting point of the filler concerned. The mounted interconnectors had the same length (170 mm) as the solar cell and were mounted along the center lines of the electrodes on the solar cell. The solar cell and the interconnectors were bonded at an offset of 5 mm in the mounting longitudinal direction. After bounding, solder protruding from the interconnector was observed and the warping / cracking condition of the solar cell was measured.

Cell warping occurred as bowing with the side bonded to the interconnector on the inside and in the longitudinal direction of the interconnectors. Specifically, the warping occurred as the result of thermal stress during cooling following bonding to the electrodes on the silicon cell with concurrent solidification of the solder, and arose because the coefficients of thermal expansion of the conductor copper and the solder were smaller than the coefficient of thermal expansion of the silicon. The amount of cell warping was determined with the warped cell facing downward on a horizontal surface by measuring the distance between the horizontal surface at the cell center region and the cell.

The results are shown in Table 2 below. Evaluation of cracking was same as in Example 2.

Table 2

| Sample | Filler material | Filler max grain diameter ($\mu$m) | Solder layer thickness ($\mu$m) | Solder protrusion | Cell warping (mm) | Cracking evaluation | Remark |
|---|---|---|---|---|---|---|---|
| L | Aluminum | 25 | 30 | O | 1.2 | O | Example |
| M | Silver | 25 | 30 | O | 1.2 | O | Example |
| N | Nickel | 25 | 30 | O | 1.1 | O | Example |
| O | Alumina | 25 | 30 | O | 0.8 | O | Example |
| P | Silica | 25 | 30 | O | 0.8 | O | Example |
| Q | – | – | 30 | X | 4.3 | X | Comparative Example |
| R | Alumina | 25 | 35 | O | 0.7 | O | Example |
| S | – | – | 35 | X | 4.2 | X | Comparative Example |

Solder protrusion and cracking differed greatly between examples containing filler and ones not containing filler. Solar cell warping after mounting of the interconnectors with surface layers containing alumina filler and the interconnector with a surface layer containing silica filler was very small and no cracking was observed either. This was because the coefficients of thermal expansion of alumina and silica are small, so that the thermal contraction of the bonded portions became small and approached that of the silicon, with the result that stress at the joint interface became small. In other words, it was found that when alumina and silica fillers are used, they act as stress mitigating layers.

Next, electrical resistance value was measured between the ends of interconnectors protruding 5 mm from the solar cell and exposed electrode surfaces not bonded to the interconnectors. The result was that the electrical resistance value of interconnectors having surface layers containing aluminum and silver as fillers was low. This was because aluminum and silver are better conductors than solder, so that current also flowed through the filler. Moreover, the interconnectors with surface layers to which no filler was added had the highest electrical resistance values. This was because the electrodes partially detached owing to the occurrence of cracking. In other words, the reduction of the electrical resistance value of the surface layer with the use of the aluminum and silver fillers was unmistakable.

Example 4

In the present example, fabrication of interconnectors (flat conductor wires) having surface layers of solder coatings containing copper filler and silica filler was conducted. As a copper core was used a flat copper wire obtained by rolling a $\Phi$1.5 mm oxygen-free copper round wire to 0.2 mm thickness, 2 mm width. The copper wire was passed through a heated tube furnace under a stream of nitrogen containing 40% hydrogen, and with the copper wire exit side of the tube furnace inserted in a hot-dip solder plating bath, the copper wire was fed out to be hot-dip plated. A solder material of Sn - 1.0 wt% Ag - 1.0 wt% Cu - 0.01 wt% Zn alloy was used, and the copper wire passed through a hot-dip plating bath maintained at 250 °C was fed out vertically using a copper wire guide and conveyed upward. The copper wire immediately after exiting the bath carried molten solder, but the solder cooled and solidified with upward movement.

As regards copper filler and silica filler supply, these fillers were mixed in advance at a volume ratio of 1:1, and as the silica was used one vapor deposition-coated with 0.2 $\mu$m of titanium. Feeders for supplying the blended filler of these mixed fillers were installed, the blended filler was brought into contact with the surface of the solder in molten state in advance, and the copper filler was pressed into the solder plating layer by immediately following pressure rollers. The fillers were individually classified using a sieve, and fillers of five maximum grain diameter levels of 3 $\mu$m, 5 $\mu$m, 15 $\mu$m, 20 $\mu$m and 30 $\mu$m were used. The volume fraction of the blended filler in the solder was 6%, and the feeder feed rate, tube furnace temperature and copper wire running velocity were regulated to control the solder thickness to 20 $\mu$m, thereby fabricating interconnectors having surface layers containing the copper filler. The interconnectors fabricated in this manner were designated samples T to X. Further, a mono-plated flat wire Y was fabricated by incorporating solely copper filler of a maximum grain diameter of 15 $\mu$m at a volume fraction of 6% and manufacturing to establish a solder average thickness of 20 $\mu$m. Moreover, a mono-plated flat wire Z was fabricated by incorporating solely titanium-coated silica filler of a maximum grain diameter of 15 $\mu$m at a volume fraction of 6% and manufacturing to establish a solder average thickness of 20 $\mu$m. $Cu_6Sn_5$ of an average thickness of 0.3 $\mu$m was formed at the solder-copper interface of all samples.

When 10 mg samples of the filler-containing solder portions of the eight types of flat wires T to Z fabricated in this manner were measured for degree of undercooling, it was found to be 14 °C.

Next, the flat wires were cut to 1.1 m length and electrical resistance was measured by the four-terminal method between voltage terminals at 1 m, by which the electrical resistance value of the samples T to X was found to be 42.7 m$\Omega$, of the sample Y to be 41.7 m$\Omega$ of the sample Z to be 43.9 m$\Omega$, and of the sample AA to be 43.1 m$\Omega$. As the solder coating thicknesses were the same and the total cross-sectional areas of the conductors were the same, the sample with the largest current carrying capacity per unit total cross-sectional area was Y, followed by samples T to X. This is because the electrical resistance value of the solder layers decreased since they contained copper filler of smaller electrical resistance than solder.

Pairs of the aforesaid interconnectors were mounted on respective electrodes formed on 190 $\mu$m thick, 170 mm square solar cells by baking two 3 mm x 5 mm sized parallel strips of silver paste applied under a set pressure. During the mounting, the bonding was performed by melting the solder at a temperature equal to or higher than the solder melting point and lower than the melting point of the copper filler. The mounted interconnectors had the same length (170 mm) as the solar cell and were mounted along the center lines of the electrodes on the solar cell. The solar cell and the interconnectors were bonded at an offset of 5 mm in the mounting longitudinal direction. After bounding, solder protruding from the interconnector was observed and the warping / cracking condition of the solar cell was measured.

Cell warping occurred as bowing with the side bonded to the interconnector on the inside and in the longitudinal direction of the interconnectors. Specifically, the warping occurred as the result of thermal stress during cooling following bonding to the electrodes on the silicon cell with concurrent solidification of the solder, and arose because the coefficients of thermal expansion of the conductor copper and the solder were smaller than the coefficient of thermal expansion of the silicon. The amount of cell warping was determined with the warped cell facing downward on a horizontal surface by measuring the distance between the horizontal surface at the cell center region and the cell.

The results are shown in Table 3 below

Table 3

| Sample | Filler max grain diameter (μm) | Copper filler volume fraction (%) | Silica filler volume fraction (%) | Solder protrusion | Cell warping (mm) | Cracking evaluation | Remark |
|---|---|---|---|---|---|---|---|
| T | 5 | 3 | 3 | Δ | 2.5 | Δ | Example |
| U | 10 | 3 | 3 | ○ | 1.5 | ○ | Example |
| V | 15 | 3 | 3 | ○ | 0.5 | ○ | Example |
| W | 20 | 3 | 3 | ○ | 0.5 | ○ | Example |
| X | 30 | 3 | 3 | ○ | 0.5 | ○ | Example |
| Y | 15 | 6 | – | ○ | 1.0 | ○ | Example |
| Z | 15 | – | 6 | ○ | 0.5 | ○ | Example |

Solder protrusion was evaluated from the degree of wetting and spreading in the direction perpendicular to the longitudinal direction of the interconnector after interconnector mounting. Symbol ○ means that the electrode and solder were wetted and a fillet was formed but is a condition where lateral wetting and spreading were uniform and confined to the width of the silver electrode. Symbol Δ is a condition where solder protruded locally but its maximum lateral spread was confined within 3 mm electrode width.

Further, cracking was evaluated as follows from observation of a polished cross-section of the interconnector and solar cell with a light microscope. Symbol ○ is a case where no cracking was observed, Symbol Δ is a case where occurrence of cracking was observed locally, and symbol X is a case where major cracking occurred and partial detachment of the solar cell and interconnector occurred.

When samples T to Z were compared on the results of joint cross-section observation, the joint thicknesses were substantially constant and the maximum grain diameters were substantially equal, while, in contrast, the joint thickness of sample AA varied greatly with location between 1 and 10 μm, making it clear that the fillers served as spacers.

When samples T to Y were compared, solder protrusion was seen to be somewhat large and moderate cracking was observed in sample T. The reason for solder protrusion being somewhat large despite the volume fraction of the filler being the same was that the maximum grain diameter of the filler was small relative to the average thickness of the solder, so that the solder protruded laterally. Further, as a result of the joint cross-section observation, slight presence of voids was found in the solder layer of sample X. This is thought to be because the maximum grain diameter of the filler was somewhat larger than the average thickness of the solder, so that solder was somewhat deficient. From these results, it was determined that the maximum grain diameter of the filler is preferably a value in the range of 50% to 100% relative to the average thickness of the solder.

Upon comparing sample V, sample Y and sample Z, which had the same filler maximum grain diameters, it was found that cell warping was smaller when sample V and sample Z were used. This was because the distance between the silicon cell and the flat wire was appropriately maintained, plus the fact that the thermal contraction of the solder was reduced by the inclusion of the silica of small coefficient of thermal expansion, so that the bending stress on the silicon diminished as a result. Taking the electrical resistance value of the interconnector into account, the result was that sample V was the best interconnector in the present example.

The reason for the amounts of silicon cell warping in the present examples all being smaller than those of Example 2 of substantially identical evaluation conditions was that the degree of undercooling of the solder was small.

Example 5

A tough pitch copper used as an electrical conductor material for a core was shaped by rolling into a flat wire shape of 1.5 mm width, 0.2 mm thickness and 50 m length, whereafter the obtained core was coated by hot-dip plating using a solder composition shown in Table 4, thereby fabricating a solar cell interconnector. The obtained solar cell interconnector had the surface of the core coated with Sn-base solder to a thickness of about 20 μm.

First, with respect to the fabricated interconnector, in order to measure the degree of undercooling of the plated solder, approximately 2 mm of the interconnector was cut out in the longitudinal direction, and cyclic measurement by DSC (differential scanning calorimetry) was performed. As stated earlier, the measurement method was to set the temperature increase and cooling rates at 10 °C/min and from the obtained DSC curve define the degree of undercooling as the difference ($\Delta T = T1 - T2$) between an onset temperature (T1) in the temperature increasing process and a peak temperature (T2) in the cooling process.

Further, 180 mm lengths were cut from the fabricated interconnector and two were connected through silver paste to one side of a 150 mm long x 150 mm wide, 200 $\mu$m thick solar cell so as to trisect the cell width, whereafter warping of the cell by the connection of the interconnectors was examined. At this time, the connected interconnectors were bonded to the cell by a core surface of 1.5 mm width x 150 mm length. Cell warping was evaluated as the difference between maximum height and minimum height when the cell was placed on a flat surface. In other words, evaluation was by the height of the highest point in the condition with one side of the cell fastened plate-like. The results are shown in Table 4. Regarding the solder composition notation in Table 4, in Example 1, for instance, Bi content is 35 mass% and the balance of Sn is 65 mass%. Further, Example 2 shows that Bi content is 35 mass%, Zn content is 0.5 mass%, and the balance of Sn is 64.5 mass% (similar applies to the other examples and comparative examples, including those in Table 5 and Table 6). The Bi added in some instances can be considered to have a function of lowering melting temperature in an Sn-base solder.

Table 4

|  | Solder composition (wt%) | Degree of undercooling (°C) | Cell warping (mm) |
|---|---|---|---|
| Example 1 | Sn-35Bi | 24 | 4.0 |
| Example 2 | Sn-35Bi-0.5Zn | 20 | 3.8 |
| Example 3 | Sn-35Bi-0.5Mg | 19 | 3.5 |
| Example 4 | Sn-35Bi-0.5Ti | 18 | 3.4 |
| Example 5 | Sn-35Bi-0.5Co | 18 | 3.5 |
| Example 6 | Sn-34Bi-0.4Zr | 19 | 3.5 |
| Example 7 | Sn-34Bi-0.3Be | 18 | 3.3 |
| Example 8 | Sn-35Bi-0.0008Zn | 24 | 4.1 |
| Example 9 | Sn-3.5Ag-0.1Zn | 15 | 3.0 |
| Example 10 | Sn-3.5Ag-0.01Mg | 16 | 3.0 |
| Example 11 | Sn-3.5Ag-0.005Co | 17 | 3.2 |
| Example 12 | Sn-3.0Ag-0.5Cu-0.05Zn | 14 | 2.9 |
| Example 13 | Sn-3.0Ag-0.5Cu-0.01Co | 14 | 2.8 |
| Example 14 | Sn-1.2Ag-0.5Cu-0.005Ti | 13 | 2.8 |
| Example 15 | Sn-1.2Ag-0.5Cu-0.005Co | 13 | 2.7 |
| Example 16 | Sn-1.0Ag-1.0Cu-0.01Zn | 14 | 2.7 |
| Example 17 | Sn-0.8Ag-1.3Cu-1Zr | 16 | 2.9 |
| Example 18 | Sn-1.2Ag-0.5Cu-0.05Ni-0.001Zr | 12 | 2.5 |
| Example 19 | Sn-1.2Ag-0.5Cu-0.05Ni-0.1Mg | 13 | 2.6 |
| Example 20 | Sn-37Pb-0.1Ag-0.01Co | 19 | 3.6 |
| Comparative Example 1 | Pb-10Sn | 35 | Cracking |
| Comparative Example 2 | Sn-57Bi | 30 | 7.5 |

Examples 1 to 20 with degrees of undercooling of less than 25 °C had cell warping of 4 mm or less and experienced no cracking. However, the cell warping of Comparative Example 2 with a degree of undercooling of 30 °C was 7.5 mm, and Comparative Example 1 with a degree of undercooling of 35 °C cracked. This is thought to be because the cell warping was large and the cell cracked because it could not withstand the stress caused by the warping.

Moreover, the degrees of undercooling of the solders of Examples 2 to 7 each added with at least one among Zn, Mg, Ti, Co, Zr and Be decreased in comparison with the degree of undercooling of Example 1 to which none of these metals was added, and the amount of cell warping also declined. Further, the degree of undercooling and amount of cell warping of Example 8 with 0.0008 mass% Zn addition were about the same as those of Example 1 with no Zn addition. Moreover, it can be seen that in the examples with Sn mass% of 60% or greater, degrees of undercooling of less than 25 °C were achieved.

Further, in order to evaluate the reliability of fabricated solar cells, the samples indicated by Examples 8, 9, 12 and 18 were subjected to high-temperature exposure testing at 100 °C for 500 hr, and the power generation efficiency decrease between before and after high-temperature exposure testing was determined. The results were 14% for Example 8, 8% for Example 9, 5% for Example 12 and 4% for Example 18, evidencing that the reliability of solders containing Ag, Cu and Ni is high.

Example 6

In the present experiment, evaluation was performed with regard to the concentration ranges of mainly Ag, Cu and Fe. An oxygen-free copper used as an electrical conductor material for a core was shaped by rolling into a flat wire shape of 2 mm width, 0.25 mm thickness and 100 m length, whereafter the obtained core was coated by hot-dip plating using a solder composition shown in Table 5, thereby fabricating a solar cell interconnector. The obtained solar cell interconnector had the surface of the core coated with Sn-base solder to a thickness of about 15 $\mu$m.

Evaluation of the degrees of undercooling of the solar cell interconnectors obtained in the foregoing was carried out by the same method as in Experiment 1. Further, 170 mm lengths were cut from the fabricated interconnector and two were connected through silver paste to one side of a 150 mm long x 150 mm wide, 150 $\mu$m thick solar cell so as to trisect the cell width, whereafter warping of the cell by the connection of the interconnectors was examined in the manner of Experiment 1. At this time, the connected interconnectors were bonded to the cell by a core surface of 2 mm width x 150 mm length. In addition, the rate of decrease in power generation efficiency was examined as in Example 5.

The results are shown in Table 5.

Table 5

| Example | Solder composition (wt%) | Degree of under-cool-ing (°C) | Cell warp-ing (mm) | Power genera-tion effi-ciency decrease rate (%) |
|---|---|---|---|---|
| 21 | Sn-0.05Ag-0.1Zn | 16 | 6.0 | 15 |
| 22 | Sn-0.1Ag-0.1Zn | 15 | 5.5 | 9 |
| 23 | Sn-3.8Ag-0.1Zn | 15 | 5.2 | 10 |
| 24 | Sn-4.5Ag-0.1Zn | 16 | 6.2 | 16 |
| 25 | Sn-0.08Cu-0.2Co | 17 | 6.5 | 14 |
| 26 | Sn-0.1Cu-0.2Co | 16 | 6.4 | 8 |
| 27 | Sn-1.5Cu-0.2Co | 17 | 6.3 | 9 |
| 28 | Sn-2.0Cu-0.2Co | 17 | 6.5 | 16 |
| 29 | Sn-1.2Ag-0.5Cu-0.1Be-0.0008Fe | 14 | 5.3 | 17 |
| 30 | Sn-1.2Ag-0.5Cu-0.1Be-0.001Fe | 14 | 5.2 | 12 |
| 31 | Sn-1.2Ag-0.5Cu-0.1Be-0.01Fe | 14 | 5.1 | 8 |
| 32 | Sn-1.2Ag-0.5Cu-0.1Be-0.1Fe | 14 | 5.1 | 9 |
| 33 | Sn-1.2Ag-0.5Cu-0.1Be-0.2Fe | 14 | 5.2 | 12 |
| 34 | Sn-1.2Ag-0.5Cu-0.1Be-0.3Fe | 14 | 5.3 | 17 |

It was found from these results that degree of undercooling decreased in every solder composition. Further, as shown in Examples 21 to 24, it can be seen that when Ag concentration was not less than 0.1 mass% and not greater than 4 mass%, power generation efficiency decline following high-temperature exposure testing was minimized and reliability was high. Moreover, as shown by Examples 25 to 28, when Cu concentration was not less than 0.1 mass% and not greater than 1.5 mass%, reliability was again high. In addition, reliability was found to be high also at Fe concentration of not less than 0.001 mass% and not greater than 0.2 mass%, more preferably not less than 0.01 mass% and not greater than 0.1 mass%.

Example 7

In the present experiment, the effect of the core was examined. As the electrical conductor of the core was used an orientation-controlled core material whose <100> direction was oriented in the wire longitudinal direction (controlled orientation copper), and comparison was made with the case of using a tough pitch material (tough pitch copper). The orientation-controlled core material and the tough pitch material were respectively shaped by rolling into a flat wire shape of 1.2 mm width, 0.2 mm thickness and 25 m length, whereafter each obtained core was coated by hot-dip plating using a solder composition shown in Table 6, thereby fabricating a solar cell interconnector. In the orientation-controlled copper with <100> direction orientation used here, the area fraction of the <100> preferred orientation region in which the <100> direction of the copper was within a direction difference of 15° relative to the thickness direction of the core material was 80%. In addition, as this orientation-controlled copper was used one whose <100> preferred orientation region within a direction difference of 15° relative to one direction within the plane of the core material was 80%. Each of the obtained solar cell interconnectors had the surface of the core coated with Sn-base solder to a thickness of about 35 $\mu$m.

200 mm lengths were cut from each fabricated interconnector and three were connected through silver paste to one side of a 180 mm long x 180 mm wide, 120 $\mu$m thick solar cell so as to quadrisect the cell width, whereafter warping of the cell by the connection of the interconnectors was examined. At this time, the connected interconnectors were bonded to the cell by a core surface of 1.2 mm width x 180 mm length.

Cell warping was evaluated as the difference between maximum height and minimum height when the cell was placed on a flat surface. In other words, evaluation was by the height of the highest point in the condition with one side of the cell fastened plate-like. Further, the degrees of undercooling of the solders were evaluated by the same method as in Example 5. The results are shown in Table 6.

Table 6

| | Solder composition (wt%) | Core material | Degree of undercooling (°C) | Cell warping (mm) |
|---|---|---|---|---|
| Example 35 | Sn-1.2Ag-0.5Cu-0.05Ni-0.01Zn | Orientation-controlled copper | 14 | 9 |
| Example 36 | | Tough pitch copper | | 16 |
| Example 37 | Sn-3.0Ag-0.5Cu-0.01Co | Orientation-Controlled copper | 16 | 11 |
| Example 38 | | Tough pitch copper | | 18 |
| Comparative Example 3 | Pb-5Sn | Tough pitch copper | 38 | Cracking |

When Sn-1.2Ag-0.5Cu-0.05Ni-0.01Zn was selected as the solder composition, the degree of undercooling was 14 °C irrespective of the type of core material. On the other hand, cell warping was 9 mm in the case of the <100> direction-controlled core material (orientation-controlled copper) and 16 mm with the tough pitch copper. When Sn-3.0Ag-0.5Cu-0.01Co was selected as the solder composition, the degree of undercooling was 16 °C, and cell warping was 11 mm with the direction-controlled copper and 18 mm with the tough pitch copper. Similarly, in the case of the interconnector exhibiting a degree of undercooling of 38 °C fabricated by coating tough pitch copper with Pb-5Sn solder, cell warping was great and the sample cracked, so that the warping could not be measured. From the foregoing results, it was ascertained that the effects of the present invention can be realized by using a solder whose degree of undercooling is less than 25 °C and using as the core material a copper orientation controlled to align the <100> direction in the wire longitudinal direction.

Aspects of the invention of the present application are summarized below.

(1) A flat conductor wire is characterized by comprising a flat electrical conductor member and a surface layer covering at least one broad face of the electrical conductor member, which surface layer has granular filler of a higher melting point than the solder dispersed in the solder.

(2) A flat conductor wire of aspect (1), characterized by the surface layer having a thickness of an average value in a range of 10 $\mu$m to 40 $\mu$m.

(3) A flat conductor wire of aspect (1) or (2), characterized by a maximum grain diameter of the filler being a value in a range of 10 $\mu$m to 40 $\mu$m.

Aspect (4): A flat conductor wire of any of aspects (1) to (3), characterized by the filler being one made of at least one metal material selected from among copper, aluminum, silver, nickel, and stainless steel.

(5) A flat conductor wire of any of aspects (1) to (3), characterized by the filler being one made of at least one ceramic material selected from between alumina and silica.

(6) A flat conductor wire of any of aspects (1) to (3), characterized by the filler containing both metal material and ceramic material.

(7) A flat conductor wire of any of aspects (1) to (6), characterized by the filler comprising ceramic, stainless steel, aluminum surface-coated with an active metal.

(8) A flat conductor wire of any of aspects (1) to (7), characterized in that the electrical conductor member is copper, the solder phase is solder containing tin, and at least part of their interface is formed with $Cu_6Sn_5$ of a thickness of 5 $\mu$m or less.

(9) A method of producing a flat conductor wire characterized by:

passing a flat electrical conductor member into a molten solder plating bath;

feeding a granular filler of higher melting point than the solder onto the solder of the electrical conductor member passed out of the plating bath with its surface covered with the solder; and

incorporating the filler into the solder to form a surface layer covering the electrical conductor member.

(10) A method of producing a flat conductor wire of aspect (9), characterized by forcibly pressing the filler onto the solder of the electrical conductor member to incorporate the filler in the solder.

(11) A method of producing a flat conductor wire, characterized by feeding a mixture of solder and granular filler of a higher melting point than the solder onto at least one broad face of a flat electrical conductor member in solid state to form a surface layer covering at least on broad face of the electrical conductor member.

(12) A solar module, characterized by comprising:

a semiconductor substrate constituting a solar cell;

an electrode formed on a surface of the semiconductor substrate; and

an interconnector connected to the electrode, wherein

the electrode is a flat conductor wire of any of aspects (1) to (8), and

the electrical conductor member and the electrode are electrically connected through the surface layer of the flat conductor wire.

(13) A solar module of aspect (12), characterized in that the interconnector also has the surface layer on the broad face destined to be a non-connecting region of the electrical conductor member with the electrode on the light-receiving side.

(14) A solar cell interconnector characterized by being a solar cell interconnector whose electrical conductor surface is coated partially or totally with Sn-base solder, which solder is of a degree of undercooling $\Delta T$ expressed by the equation below of less than 25 °C:

$$\Delta T = T1 - T2$$

(where T1 is an onset temperature representing a rise of an endothermic peak during heating at a temperature increase rate of 10 °C/min in differential scanning calorimetry and T2 is a peak temperature of an exothermic peak during cooling at a cooling rate of 10 °C/min in the aforesaid calorimetry).

(15) A solar cell interconnector of aspect (14), characterized in that the solder contains at least one of Zn, Mg, Ti, Co, Zr and Be in a total, in mass%, of not less than 0.001% and not greater than 2%.

(16) A solar cell interconnector of aspect of (14) or (15), characterized in that the solder contains Sn at 60 mass% or greater.

(17) A solar cell interconnector of any of aspects (14) to (16), characterized in that the solder contains Ag, in mass%, at not less than 0.1% and not greater than 4%.

(18) A solar cell interconnector of any of aspects (14) to (17), characterized in that the solder contains Cu, in mass%, at not less than 0.1% and not greater than 1.5%.

(19) A solar cell interconnector of any of aspects (14) to (18), characterized in that the solder contains at least one of Fe and Ni in a total, in mass%, of not less than 0.001% and not greater than 0.2%.

(20) A solar cell interconnector of any of aspects (14) to (19), characterized in that the solder is Pb-free solder.

(21) A solar cell interconnector of any of aspects (14) to (19), characterized in that the solder contains 30 to 45 mass% Pb.

(22) A method of producing a solar cell interconnector whose electrical conductor surface is coated partially or totally with Sn-base solder, which method of producing a solar cell interconnector is characterized by coating an electrical conductor with Sn-base solder using a hot-dip coating containing 60 mass% or greater of Sn and containing at least one of Zn, Mg, Ti, Co, Zr and Be in a total of not less than 0.001 mass% and not greater than 2 mass%.

EXPLANATION OF REFERENCE SYMBOLS

| | |
|---|---|
| 1 | Electrical conductor member |
| 2 | Surface layer |
| 2a | Solder coating |
| 2b | Filler |
| 10 | Solar cell interconnector |
| 11 | Solar cell |
| 12 | Front electrode |
| 13 | Rear electrode |
| 14 | EVA adhesion layer |
| 15 | Protective glass 15 |
| 16 | Back film |
| 100 | Solar module |

**Claims**

1. A solar cell interconnector **characterized by** comprising:

   an electrical conductor member; and
   a surface layer formed on at least one broad face of the electrical conductor member,
   which surface layer functions to reduce stress caused by difference between coefficient of thermal expansion of the electrical conductor member and coefficient of thermal expansion of a solar cell occurring when the solar cell interconnector is bonded to the solar cell.

2. A solar cell interconnector as set out in claim 1, wherein the surface layer is formed on at least one broad face of the electrical conductor member and comprises solder and a granular filler of higher melting point than the solder dispersed within the solder.

3. A solar cell interconnector as set out in claim 2, wherein the surface layer has a thickness of an average value in a range of 10 $\mu$m to 40 $\mu$m.

4. A solar cell interconnector as set out in claim 2, wherein the filler has a maximum grain diameter of a value in a range of 10 $\mu$m to 40 $\mu$m.

5. A solar cell interconnector as set out in any of claims 2 to 4, wherein the filler comprises at least one metal material selected from among copper, aluminum, silver, nickel, and stainless steel.

6. A solar cell interconnector as set out in any of claims 2 to 4, wherein the filler comprises at least one ceramic material selected from between alumina and silica.

7. A solar cell interconnector as set out in any of claims 2 to 4, wherein the filler comprises at least one metal material selected from among copper, aluminum, silver, nickel and stainless steel and at least one ceramic material selected from between alumina and silica.

8. A solar cell interconnector as set out in any of claims 2 to 4, wherein the filler comprises ceramic, stainless steel or aluminum, surface-coated with an active metal.

9. A solar cell interconnector **characterized in that** the surface layer is a surface layer formed on at least part of a surface of the electrical conductor member, which surface layer comprises Sn-base solder of a degree of undercooling $\Delta T$ determined by $\Delta T = T1 - T2$ of less than 25 °C,
(where T1 is an onset temperature representing a rise of an endothermic peak during heating at a temperature increase rate of 10 °C/min in differential scanning calorimetry and T2 is a peak temperature of an exothermic peak during cooling at a cooling rate of 10 °C/min in the aforesaid calorimetry).

10. A solar cell interconnector as set out in claim 9, wherein the solder contains at least one of Zn, Mg, Ti, Co, Zr and Be in a total, in mass%, of not less than 0.001% and not greater than 2%.

11. A solar cell interconnector as set out in claim 9 or 10, **characterized in that** the solder contains Sn at 60 mass% or greater.

12. A solar cell interconnector as set out in any of claims 9 to 11, **characterized in that** the solder contains Ag, in mass%, at not less than 0.1% and not greater than 4%.

13. A solar cell interconnector as set out in any of claims 9 to 12, **characterized in that** the solder contains Cu, in mass%, at not less than 0.1% and not greater than 1.5%.

14. A solar cell interconnector as set out in any of claims 9 to 13, **characterized in that** the solder contains at least one of Fe and Ni in a total, in mass%, of not less than 0.001% and not greater than 0.2%.

15. A solar cell interconnector as set out in any of claims 9 to 14, **characterized in that** the solder is Pb-free solder.

16. A solar cell interconnector as set out in any of claims 9 to 14, **characterized in that** the solder contains 30 to 45 mass% Pb.

17. A solar module, **characterized by** comprising:

    a semiconductor substrate constituting a solar cell;
    an electrode formed on a surface of the semiconductor substrate; and
    a solar cell interconnector, which is a solar cell interconnector set out in any of claims 1 to 16, bonded to the electrode,
    the electrical conductor member and the electrode being electrically connected through the surface layer of the flat conductor wire.

18. A solar module as set out in claim 16, **characterized in that** the interconnector also has the surface layer on the broad face destined to be a non-connecting region of the electrical conductor member with the electrode on the light-receiving side.

# Fig.1

EP 2 717 330 A1

Fig.2

(a)

(b)

EP 2 717 330 A1

# Fig.3

EP 2 717 330 A1

Fig.4

# Fig.5

(a)

(b)

# Fig.6

EP 2 717 330 A1

# Fig.7

# Fig.8

<table>
<tr><td colspan="2"><b>INTERNATIONAL SEARCH REPORT</b></td><td>International application No.<br>PCT/JP2012/063527</td></tr>
</table>

A. CLASSIFICATION OF SUBJECT MATTER
*H01L31/042*(2006.01)i, *B23K35/26*(2006.01)i, *C23C2/08*(2006.01)i, *C23C2/10*
(2006.01)i, *C23C2/38*(2006.01)i

According to International Patent Classification (IPC) or to both national classification and IPC

B. FIELDS SEARCHED

Minimum documentation searched (classification system followed by classification symbols)
H01L31/042, B23K35/26, C23C2/08, C23C2/10, C23C2/38

Documentation searched other than minimum documentation to the extent that such documents are included in the fields searched

| Jitsuyo Shinan Koho | 1922-1996 | Jitsuyo Shinan Toroku Koho | 1996-2012 |
| Kokai Jitsuyo Shinan Koho | 1971-2012 | Toroku Jitsuyo Shinan Koho | 1994-2012 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X<br>A | WO 2008/139995 A1 (Hitachi Chemical Co., Ltd.),<br>20 November 2008 (20.11.2008),<br>paragraphs [0005], [0105] to [0107]<br>& JP 2012-9884 A      & US 2010/0108141 A1<br>& EP 2146404 A1      & KR 10-2009-0098871 A<br>& CN 101669258 A      & TW 200919750 A | 1,17<br>2-16,18 |
| Y | JP 62-197292 A (Mitsubishi Metal Corp.),<br>31 August 1987 (31.08.1987),<br>page 2, upper left part, line 10 to page 3,<br>upper left part, line 15<br>(Family: none) | 1-8,17 |
| Y | JP 2008-182171 A (Hitachi Cable, Ltd.),<br>07 August 2008 (07.08.2008),<br>paragraphs [0002] to [0005], [0045]<br>(Family: none) | 1-18 |

☒ Further documents are listed in the continuation of Box C.     ☐ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search<br>06 August, 2012 (06.08.12) | Date of mailing of the international search report<br>14 August, 2012 (14.08.12) |
|---|---|
| Name and mailing address of the ISA/<br>Japanese Patent Office | Authorized officer |
| Facsimile No. | Telephone No. |

Form PCT/ISA/210 (second sheet) (July 2009)

**INTERNATIONAL SEARCH REPORT**

International application No.

PCT/JP2012/063527

C (Continuation).  DOCUMENTS CONSIDERED TO BE RELEVANT

| Category* | Citation of document, with indication, where appropriate, of the relevant passages | Relevant to claim No. |
|---|---|---|
| Y | JP 2002-301588 A  (Hitachi, Ltd.),<br>15 October 2002 (15.10.2002),<br>paragraph [0008]<br>& US 2006/0061974 A1     & WO 2002/049797 A1<br>& AU 1637302 A            & TW 592871 B<br>& CN 1873971 A | 5 |
| Y | JP 2006-263774 A  (Toshiba Corp.),<br>05 October 2006 (05.10.2006),<br>paragraph [0035]<br>(Family: none) | 6 |
| Y | WO 2010/033107 A1  (AGERE SYSTEMS, INC.),<br>25 March 2010 (25.03.2010),<br>page 3, line 20 to page 14, line 6<br>& JP 2012-503309 A       & EP 2340559 A1<br>& CN 102197477 A          & TW 201023282 A | 1,9-18 |
| A | JP 3-281088 A  (Taiyo Yuden Co., Ltd.),<br>11 December 1991 (11.12.1991),<br>entire text; all drawings<br>(Family: none) | 1-18 |
| A | JP 2008-178903 A  (Mitsubishi Materials Corp.),<br>07 August 2008 (07.08.2008),<br>entire text; all drawings<br>(Family: none) | 1-18 |
| A | JP 6-285686 A  (NEC Kansai, Ltd.),<br>11 October 1994 (11.10.1994),<br>entire text; all drawings<br>(Family: none) | 1-18 |

Form PCT/ISA/210 (continuation of second sheet) (July 2009)

**INTERNATIONAL SEARCH REPORT**

| International application No. |
|---|
| PCT/JP2012/063527 |

**Box No. II      Observations where certain claims were found unsearchable (Continuation of item 2 of first sheet)**

This international search report has not been established in respect of certain claims under Article 17(2)(a) for the following reasons:

1. ☐ Claims Nos.:
because they relate to subject matter not required to be searched by this Authority, namely:

2. ☐ Claims Nos.:
because they relate to parts of the international application that do not comply with the prescribed requirements to such an extent that no meaningful international search can be carried out, specifically:

3. ☐ Claims Nos.:
because they are dependent claims and are not drafted in accordance with the second and third sentences of Rule 6.4(a).

**Box No. III      Observations where unity of invention is lacking (Continuation of item 3 of first sheet)**

This International Searching Authority found multiple inventions in this international application, as follows:

Document 1 (WO 2008/139995 A1, Hitachi Chemical Co., Ltd.) sets forth an interconnector for solar cells, which is obtained by providing the both surfaces of a copper foil with conductive adhesive layers.

In this connection, the conductive adhesive layers reduce the stress caused by the difference between the thermal expansion coefficient of the copper foil and that of a solar cell.

Consequently, the invention of claim 1 is same as the invention disclosed in the document 1, and claim 1 does not have a special technical feature.

Accordingly, the present application involves two inventions as follows. (Continued to extra sheet)

1. ☒ As all required additional search fees were timely paid by the applicant, this international search report covers all searchable claims.

2. ☐ As all searchable claims could be searched without effort justifying additional fees, this Authority did not invite payment of additional fees.

3. ☐ As only some of the required additional search fees were timely paid by the applicant, this international search report covers only those claims for which fees were paid, specifically claims Nos.:

4. ☐ No required additional search fees were timely paid by the applicant. Consequently, this international search report is restricted to the invention first mentioned in the claims; it is covered by claims Nos.:

**Remark on Protest**

☐ The additional search fees were accompanied by the applicant's protest and, where applicable, the payment of a protest fee.

☐ The additional search fees were accompanied by the applicant's protest but the applicable protest fee was not paid within the time limit specified in the invitation.

☒ No protest accompanied the payment of additional search fees.

Form PCT/ISA/210 (continuation of first sheet (2)) (July 2009)

**INTERNATIONAL SEARCH REPORT**

International application No.

PCT/JP2012/063527

Continuation of Box No.III of continuation of first sheet(2)

(Invention 1) claims 1-8, and claim 17 dependent on any one of claims 1-8

(Invention 2) claims 9-16, and claims 17 and 18 each of which is dependent on any one of claims 9-16

Meanwhile, although claim 9 is set forth as an independent claim, it is judged that claim 9 is dependent on claim 1.

Form PCT/ISA/210 (extra sheet) (July 2009)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 11021660 A
- JP 2006080217 A
- JP 2008021831 A
- JP 2008168339 A
- JP 2008098607 A
- JP 2010073445 A
- JP 8174276 A
- JP 63180395 A
- JP 9206983 A

**Non-patent literature cited in the description**

- **YUJU ENDO et al.** *Hitachi Cable,* 2007, vol. 26 (1), 15